# EUROPEAN PATENT SPECIFICATION

(11) **EP 2 299 498 B1**
(45) Date of publication and mention of the grant of the patent: **11.12.2013**
(21) Application number: 09758344.7
(22) Date of filing: 03.06.2009
(51) Int. Cl.: H01L 21/677, H01L 31/18, C23C 16/458

(54) **Thin-film solar cell manufacturing apparatus**
Vorrichtung zur Herstellung einer Dünnfilm-Solarzelle
Appareil de fabrication de cellules solaires en film mince

(30) Priority: 06.06.2008 JP 2008149939
(43) Date of publication of application: 23.03.2011
(73) Proprietor: ULVAC, INC., Chigasaki-shi Kanagawa 253-8543 (JP)
(72) Inventor: SHIMIZU Yasuo, Chigasaki-shi Kanagawa 253-8543 (JP); OGATA Hideyuki, Chigasaki-shi Kanagawa 253-8543 (JP); MATSUMOTO Koichi, Chigasaki-shi Kanagawa 253-8543 (JP); NOGUCHI Takafumi, Chigasaki-shi Kanagawa 253-8543 (JP); WAKAMORI Jouji, Chigasaki-shi Kanagawa 253-8543 (JP); OKAYAMA Satohiro, Chigasaki-shi Kanagawa 253-8543 (JP); MORIOKA Yawara, Chigasaki-shi Kanagawa 253-8543 (JP); SUGIYAMA Noriyasu, Chigasaki-shi Kanagawa 253-8543 (JP); SHIGETA Takashi, Chigasaki-shi Kanagawa 253-8543 (JP); KURIHARA Hiroyuki, Chigasaki-shi Kanagawa 253-8543 (JP)
(74) Representative: Eisenführ, Speiser & Partner
(86) International application number: PCT/JP2009/060143
(87) International publication number: WO 2009/148077

(56) References cited:
- EP-A1- 1 359 611
- EP-A1- 1 622 192
- WO-A1-2008/062663
- JP-A- 8 236 795
- JP-A- 2001 118 907
- JP-A- 2002 083 774
- JP-A- 2002 167 036
- JP-A- 2004 335 601
- JP-A- 2004 349 475
- JP-A- 2006 054 284
- JP-A- 2006 264 826
- JP-A- 2007 288 036
- US-A1- 2007 017 445

## Description

### TECHNICAL FIELD

The present invention relates to a thin-film solar cell manufacturing apparatus.

### BACKGROUND ART

Most current solar cells are a single crystal Si type solar cell and a polycrystal Si type solar cell. However, due to material shortages of Si or the like, demand has recently been increasing for thin-film solar cells formed with a thin-film Si-layer in which manufacturing costs are low and the risk of material shortages is low. Moreover, in addition to conventional thin-film solar cell with only an a-Si (amorphous silicon) layer, a demand for tandem-type thin-film solar cells has recently been increasing, in which the conversion efficiency of the tandem-type thin-film solar cells is improved by laminating an a-Si-layer and a µc-Si (microcrystalline silicon) layer.

A plasma-CVD apparatus is often used for forming a thin-film Si-layer (semiconductor layer) for the thin-film solar cells. As such a plasma-CVD apparatus, for example a single-wafer-type PE-CVD (plasma CVD) apparatus, an in-line type PE-CVD apparatus, a batch-type PE-CVD apparatus, and the like exist.

Here, when the conversion efficiency of a thin-film solar cell is taken into consideration, the µc-Si layer of the tandem-type thin-film solar cell needs to be formed with a film thickness (about 1.5 µm) of approximately five times larger than that of the a-Si layer. Additionally, since the µc-Si layer needs to uniformly form a good microcrystalline layer, there is a limit on increasing a film formation rate. Accordingly, there is a need to increase the number of batch processing to improve productivity. That is, an apparatus which can realize higher throughput at a lower film formation rate is needed.

Additionally, a CVD apparatus which can form a high-quality thin film and can lower manufacturing costs or maintenance costs is proposed in Patent Literature 1. The CVD apparatus of Patent Literature 1 includes a substrate (base) delivery-dispensing apparatus, a film forming chamber group which can store a plurality of substrates, a transfer chamber, and a chamber transfer apparatus. A shutter with airtightness is provided at an inlet and outlet port of a film forming chamber of a film forming section, and an inlet and outlet port of a storage chamber of the transfer chamber is always open. Also, when forming a Si-layer on a substrate, the transfer chamber is transferred to a position of the substrate delivery-dispensing apparatus by the chamber transfer apparatus, and a substrate carrier is transferred to the transfer chamber side. Additionally, the transfer chamber and the film forming section are joined together by the chamber transfer apparatus, the substrate carrier is transferred to the film forming section, and a Si-layer is formed on the substrate.

### [Patent Literature]

[Patent Literature 1] Japanese Unexamined Patent Application, First

EP 1 622 192 A discloses a substrate transfer device for a thin-film deposition apparatus. Partition panels each with an opening larger than a substrate and facing an electrode are arranged on a transfer carriage, a picture-frame-like substrate holder with the substrate fitted thereto being arranged on a side of the partition panel away from the electrode such that the substrate is arranged substantially at a center of the opening of the partition panel and the outer peripheral edge of the substrate holder is masked with the partition panel.

EP 1 359 611 A1 discloses a plasma CVD method and plasma CVD apparatus, which makes it possible to form thin films of uniform thickness on both surfaces of a substrate without the step of turning a substrate over.

US 2007/0017445 A1 discloses a method for making a film stack containing one or more silicon-containing layers and one or more metal-containing layers and a substrate processing system for forming the film stack on a substrate. The substrate processing system includes one or more transfer chambers coupled to one or more load lock chambers and two or more different types of process chambers.

JP 2001 118907 A discloses a substrate transporting equipment that is provided with a vacuum treatment chamber for treating a substrate at a reduced pressure, transporting trucks for delivering or accepting substrates to or from the chamber, substrate supporting mechanisms which support the substrates in tilted position on the transporting trucks, a double-side type of film forming unit arranged in the chamber, a pair of heater units which is movable regarding the film forming unit and comprises a heater cover covering a heat generating plane of the heater, and heater cover moving members which moves the heater cover in the direction substantially rectangular with the heat generating plane, while keeping a parallel relation with the heat generating plane on a flat plane and puts the cover tightly in contact with the substrate.

### DISCLOSURE OF THE INVENTION

### [Problems to be Solved by the Invention]

Meanwhile, in the CVD apparatus of Patent Literature 1, in order to form a thin-film Si-layer on a substrate, the transfer chamber is joined to the film forming section, the shutter of the film forming section is opened after the inside of the transfer chamber is brought into a vacuum state, and the substrate carrier is transferred to the film forming section from the transfer chamber. Thereafter, the substrate is heated within the film forming section, and a thin-film Si-layer is formed on the substrate by a plasma CVD method. After the film formation of the thin-film Si-layer is ended, the substrate is cooled, and the substrate can be conveyed to the other processing chambers. Accordingly, although Si-layers can be simultaneously formed on a plurality of substrates, a number of other steps are required besides the film forming step to the substrate, in order to form a thin-film Si-layer on a substrate. Additionally, in order to realize a high throughput, it is necessary to increase the installation number of CVD apparatuses. However, when the effects of the apparatuses on the installation area and cost are taken into consideration, there is a limit on increasing the installation number of the CVD apparatuses.
Additionally, a pinion gear which has a drive source for transferring a substrate carrier is provided within the film forming chamber of the film forming section related to the Patent Literature 1. That is, the substrate carrier can be transferred by driving the pinion gear. Additionally, since a Si-layer is formed on a substrate, and simultaneously the thin-film Si-layer deposits even within the film forming chamber of the film forming section, it is necessary to perform maintenance periodically. In the configuration of the CVD apparatus of the Patent Literature 1, it is necessary to provide a drive part which drives the pinion gear within the film forming chamber of the film forming section. Accordingly, the configuration within the film forming chamber of the film forming section becomes complicated, and a long time is taken for maintenance. Since it become impossible to use the film forming chamber during maintenance, there is a problem in that production efficiency decreases.
Additionally, when easiness of cleaning or the contamination caused by driving is taken into consideration, it is preferable that driven parts or rotating parts be few in the film forming chamber. That is, it is preferable to install a mechanism which transfers the substrate carrier outside the film forming chamber, and to install rotating parts or the like on the side of the substrate carrier.

The object of the present invention is to provide a thin-film solar cell manufacturing apparatus which can reduce the maintenance frequency of the film forming chamber and can improve production efficiency.

### [Means for Solving the Problem]

A thin-film solar cell manufacturing apparatus related to one aspect of the present invention includes: a film forming chamber that is evacuated to a reduced pressure and forms a film on a substrate using a CVD method; a loading-ejecting chamber that is connected to the film forming chamber via a first opening-closing part and that is switchable between atmospheric pressure and reduced pressure; a transfer rail that is laid at the film forming chamber and the loading-ejecting chamber; a carrier that moves along the transfer rail and holds the substrate in a vertical posture where a surface to be film-formed of the substrate is parallel to a direction of gravitational force; and a carrier transfer mechanism that transfers the carrier, wherein the carrier transfer mechanism is provided in the loading-ejecting chamber, wherein the carrier transfer mechanism includes: a locking portion that locks the carrier; a pair of guide members that are provided at both ends of the locking portion, and are disposed parallel to the transfer rail; a transfer apparatus that moves the locking portion along the guide members, and a transfer arm that is attached to the transfer apparatus and to the locking portion, and wherein the carrier transfer mechanism simultaneously transfers a plurality of the carrier from the loading-ejecting chamber to the film forming chamber, and from the film forming chamber to the loading-ejecting chamber, according to claim 1.
A configuration may be adopted in which the thin-film solar cell manufacturing apparatus further includes a substrate replacement chamber that is connected to the loading-ejecting chamber via a second opening-closing part; a substrate conveying mechanism that performs an operation of attaching the substrate to the carrier and an operation of removing the substrate from the carrier; a storage mechanism that stores at least one of the substrate attached to the carrier and the substrate removed from the carrier; wherein the carrier transfer mechanism transfers the carrier between the loading-ejecting chamber and the substrate replacement chamber; the substrate conveying mechanism performs the operation of attaching the substrate to the carrier and the operation of removing the substrate from the carrier within the substrate replacement chamber; and the substrate conveying mechanism holds the substrate by suctioning a rear surface of the surface to be film-formed of the substrate, and transfers the substrate between the substrate replacement chamber and the storage mechanism.
A configuration may be adopted in which the carrier holds a plurality of the substrates so that the substrates are parallel to each other and face each other.
A configuration may be adopted in which the film forming chamber has a plurality of cathodes and anodes which face both surfaces of the cathodes; and the carrier is transferred to the film forming chamber so that the substrate is inserted between the cathode and the anode.
A configuration may be adopted in which the film forming chamber has a film forming unit which has one cathode and two cathodes which face both surfaces of the cathode; and the carrier is transferred to the film forming chamber so that the substrate is inserted between the cathode and the anode.
The film forming chamber may have a plurality of the film forming units.
A configuration may be adopted in which the film forming unit is mounted removably from the film forming chamber.
A configuration may be adopted in which the storage mechanism stores the substrate in a horizontal posture in which the surface to be film-formed of the substrate is horizontal; the carrier stores the substrate in a vertical posture in which the surface to be film-formed of the substrate is vertical; and the substrate conveying mechanism has a rotating mechanism which rotates the substrate between the vertical posture and the horizontal posture.
A configuration may be adopted in which the thin-film solar cell manufacturing apparatus further includes a plurality of process modules in which one film forming chamber is connected to one loading-ejecting chamber; and the plurality of process modules is arranged in parallel.
A plurality of the film forming chambers may be connected to one loading-ejecting chamber.
A configuration may be adopted in which the thin-film solar cell manufacturing apparatus further includes a plurality of the process modules in which one film forming chamber is connected to one loading-ejecting chamber; the plurality of process modules are arranged in parallel; and one substrate conveying mechanism is installed in common to the plurality of process modules.

According to the above aspect, in the film forming chamber, only the transfer rail is provided without a drive source for transferring the carrier. Accordingly, it is not necessary to perform maintenance on a drive source within the film forming chamber unlike a conventional technique, and the maintenance frequency of the film forming chamber can be reduced to improve production efficiency.

According to the above aspect, the drive mechanism can suction only the rear surface of the surface to be film-formed of the substrate, and transfer the substrate. Therefore, particularly when moving a post-processed substrate, the substrate can be moved without contact with a film-formed region by the drive mechanism. Accordingly, the quality of the film formation face can be reliably maintained when the substrate is conveyed, and yield can be improved.

According to the above aspect, the area required for a substrate to move within the apparatus can be reduced. Thus, the apparatus can be miniaturized, and a larger number of apparatuses can be arranged in the same installation area as in the conventional technique. Accordingly, the number of substrates on which films can be simultaneously formed can be increased, and productivity can be improved. Additionally, when a film is formed in a state where a substrate is erected in the vertical direction so that the surface to be film-formed of the substrate becomes substantially parallel to the direction of gravitational force, particles generated when forming a film can be kept from depositing on the film formation face of the substrate. Accordingly, a high-quality semiconductor layer can be formed on the substrate.

According to the above aspect, since films can be simultaneously formed on a plurality of substrates in one carrier, productivity can be further improved.

According to the above aspect, while quality of the formed film can be maintained during movement by making the surface to be film-formed of a substrate substantially parallel to the horizontal direction when the substrate is stored in the conveying mechanism and conveyed to other processing chambers, and the area required for a substrate to move within the apparatus can be reduced by making the surface to be film-formed of the substrate substantially parallel to the direction of gravitational force when the substrate is attached to the carrier. Accordingly, production efficiency can be improved.

According to the above aspect, the number of substrates on which films can be simultaneously formed can be further increased by arranging a plurality of process modules in parallel. Therefore, even when a film is formed on a substrate at a low rate, high throughput can be realized. Additionally, the installation time (building time of a manufacturing line) of the apparatus when the manufacturing line is built in a factory or the like can be shortened by integrating the apparatus as the process module. Moreover, when maintenance of the film forming chamber is performed, it becomes unnecessary to stop the whole manufacturing line by performing maintenance every process module. Accordingly, a decrease in production efficiency during maintenance can be suppressed to a minimum.

According to the above aspect, a substrate attached to a carrier can be moved within the loading-ejecting chamber. Therefore, different film forming materials can be supplied in each film forming chambers respectively, and a plurality of layers with different film forming materials can be more efficiently formed on a substrate.

### [Advantageous Effects]

According to the aspect of the present invention, in the film forming chamber, only the transfer rail is provided without a drive source for transferring the carrier. Accordingly, it is not necessary to perform maintenance on a drive source within the film forming chamber unlike in the conventional technique, and the maintenance frequency of the film forming chamber can be reduced to improve production efficiency.

### BRIEF DESCRIPTION OF THE DRAWINGS

FIG. 1 is a schematic sectional view of a thin-film solar cell related to an embodiment of the present invention.
FIG. 2 is a schematic configuration view of a thin-film solar cell manufacturing apparatus related to an embodiment of the present invention.
FIG. 3A is a perspective view of a film forming chamber related to an embodiment of the present invention.
FIG. 3B is a perspective view of the film forming chamber related to an embodiment of the present invention when seeing from a different angle.
FIG. 3C is a side view of the film forming chamber related to an embodiment of the present invention.
FIG. 4A is a perspective view of an electrode unit related to an embodiment of the present invention.
FIG. 4B is a perspective view of the electrode unit related to an embodiment of the present invention when seeing from a different angle.
FIG. 4C is a partial perspective view of the electrode unit related to an embodiment of the present invention.
FIG. 4D is a partial sectional view of a cathode unit and anode unit of the electrode unit related to an embodiment of the present invention.
FIG. 5A is a perspective view of a loading-ejecting chamber related to an embodiment of the present invention.
FIG. 5B is a perspective view of the loading-ejecting chamber related to an embodiment of the present invention when seeing from a different angle.
FIG. 6 is a schematic configuration view of a push-pull mechanism related to an embodiment of the present invention.
FIG. 7A is a perspective view of a schematic configuration of a substrate replacement chamber related to an embodiment of the present invention.
FIG. 7B is a front view of the schematic configuration of the substrate replacement chamber related to an embodiment of the present invention.
FIG. 8 is a perspective view of a substrate storage holder related to an embodiment of the present invention.
FIG. 9 is a perspective view of a carrier related to an embodiment of the present invention.
FIG. 10 is an explanatory view (1) showing a process of a manufacturing method of thin-film solar cell related to an embodiment of the present invention.
FIG. 11 is an explanatory view (2) showing a process of a manufacturing method of thin-film solar cell related to an embodiment of the present invention.
FIG. 12 is an explanatory view (3) showing a process of a manufacturing method of thin-film solar cell related to an embodiment of the present invention.
FIG. 13 is an explanatory view (4) showing a process of a manufacturing method of thin-film solar cell related to an embodiment of the present invention.
FIG. 14 is an explanatory view (5) showing a process of a manufacturing method of thin-film solar cell related to an embodiment of the present invention.
FIG. 15A is an explanatory view (1) showing the operation of a push-pull mechanism related to an embodiment of the present invention.
FIG. 15B is an explanatory view (2) showing the operation of the push-pull mechanism related to an embodiment of the present invention.
FIG. 16 is an explanatory view (6) showing a process of a manufacturing method of thin-film solar cell related to an embodiment of the present invention.
FIG. 17 is an explanatory view (7) showing a process of a manufacturing method of thin-film solar cell related to an embodiment of the present invention.
FIG. 18 is an explanatory view (8) showing a process of the manufacturing method of thin-film solar cell related to an embodiment of the present invention, and showing a schematic section when substrates are inserted into the electrode unit.
FIG. 19 is an explanatory view (9) showing a process of a manufacturing method of thin-film solar cell related to an embodiment of the present invention.
FIG. 20 is an explanatory view (10) showing a process of a manufacturing method of thin-film solar cell related to an embodiment of the present invention.
FIG. 21 is an explanatory view (11) showing a process of the manufacturing method of thin-film solar cell related to an embodiment of the present invention, and showing a partial section when substrates are set in the electrode unit.
FIG. 22 is an explanatory view (12) showing a process of a manufacturing method of thin-film solar cell related to an embodiment of the present invention.
FIG. 23 is an explanatory view (13) showing a process of a manufacturing method of thin-film solar cell related to an embodiment of the present invention.
FIG. 24 is an explanatory view (14) showing a process of a manufacturing method of thin-film solar cell related to an embodiment of the present invention.
FIG. 25 is an explanatory view (15) showing a process of a manufacturing method of thin-film solar cell related to an embodiment of the present invention.
FIG. 26 is a schematic configuration view showing another aspect of the thin-film solar cell manufacturing apparatus related to an embodiment of the present invention.
FIG. 27 is a schematic configuration view showing another arrangement method of the thin-film solar cell manufacturing apparatus related to an embodiment of the present invention.
FIG. 28 is a schematic configuration view showing still another arrangement method of the thin-film solar cell manufacturing apparatus related to an embodiment of the present invention.

### BEST MODES FOR CARRYING OUT THE INVENTION

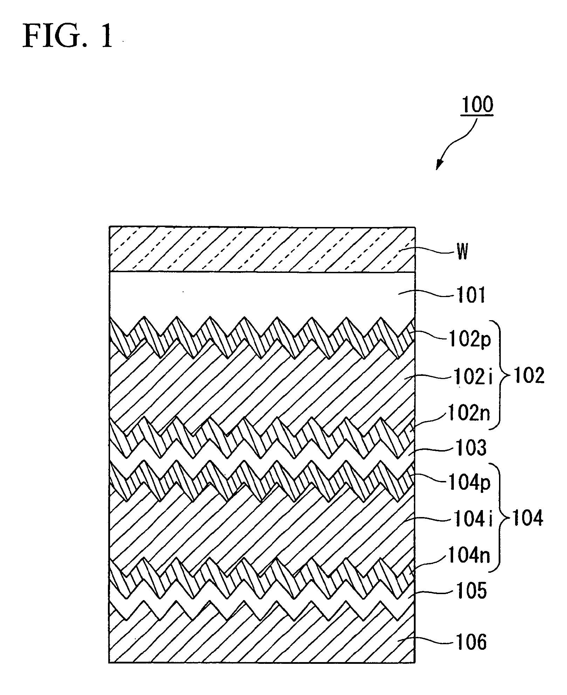

A thin-film solar cell manufacturing apparatus related to an embodiment of the present invention will be described below with reference to FIGS. 1 to 28.

### <Thin-film Solar Cell>

FIG. 1 is a schematic sectional view of a thin-film solar cell. As shown in FIG. 1, in a thin-film solar cell 100, a substrate W which constitutes the surface of the thin-film solar cell 100, a top electrode 101 made of a transparent-electroconductive film, a top cell 102 made of amorphous silicon, an intermediate electrode 103 made of a transparent-electroconductive film, a bottom cell 104 made of microcrystalline silicon, a buffer layer 105 made of a transparent-electroconductive film, and a back electrode 106 made of a metal film are laminated in the top-bottom order (from the top to the bottom) of the drawing. Among these, the top electrode 101 is laminated on the substrate W. The intermediate electrode 103 is laminated between the top cell 102 and the bottom cell 104. That is, the thin-film solar cell 100 is an a-Si/microcrystal Si tandem-type solar cell. In the thin-film solar cell 100 of such tandem structure, power generation efficiency can be improved by absorbing short-wavelength light by the top cell 102 and absorbing long-wavelength light by the bottom cell 104.

The top cell 102 has a three-layer structure configured by laminating a p-layer 102p, an i-layer 102i, and an n-layer 102n in top-bottom order in the drawing. The three-layer structure of the p-layer 102p, i-layer 102i, and n-layer 102n of the top cell 102 is formed from amorphous silicon. Additionally, the bottom cell 104 has a three-layer structure configured by laminating a p-layer 104p, an i-layer 104i, and an n-layer 104n in top-bottom order in the drawing. The three-layer structure of the p-layer 104p, i-layer 104i, and n-layer 104n of the bottom cell 104 is made of microcrystalline silicon.

In the thin-film solar cell 100 configured in the above way, when an energy particle called a photon in sunlight strikes the i-layer, an electron and a hole are generated by a photovoltaic effect, the electron moves toward the n-layer and the hole moves toward the p-layer. Light energy can be converted into electrical energy by taking out the electron generated by the photovoltaic effect by the top electrode 101 and the back electrode 106.

Additionally, the intermediate electrode 103 is provided between the top cell 102 and the bottom cell 104, whereby a part of the light which passes through the top cell 102 and reaches the bottom cell 104 is reflected by the intermediate electrode 103 and incident on the top cell 102. Accordingly, the sensitivity characteristics of the cell are improved, and the power generation efficiency can be improved.

Additionally, the sunlight incident from the glass substrate W side passes through the respective layers, and is reflected by the back electrode 106. In order to improve the conversion efficiency of light energy, the thin-film solar cell 100 employs a texture structure which aims to achieve a prismatic effect which extends the optical path of the sunlight which incident on the top electrode 101, and the confinement effect of light.

### <THIN-FILM SOLAR CELL MANUFACTURING APPARATUS>

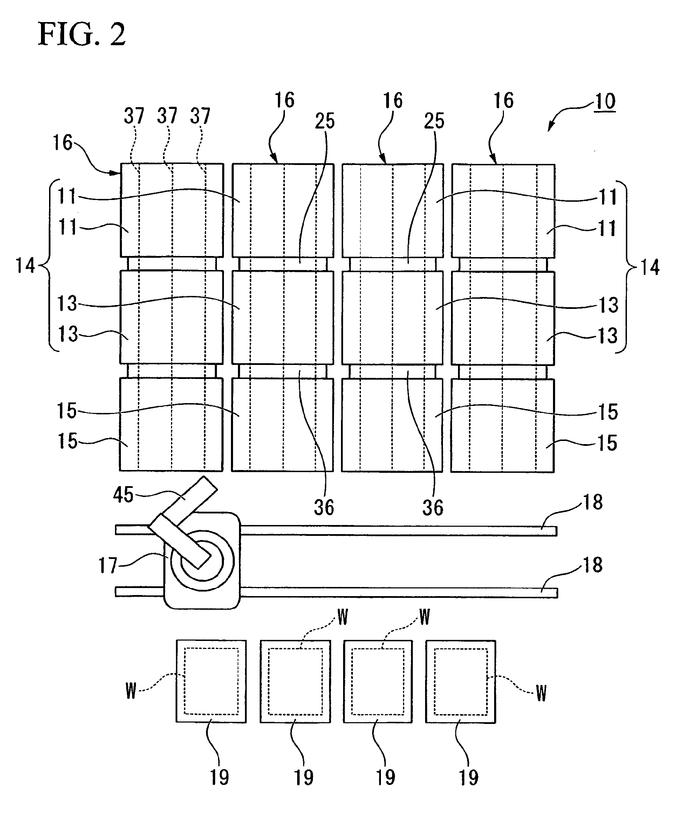

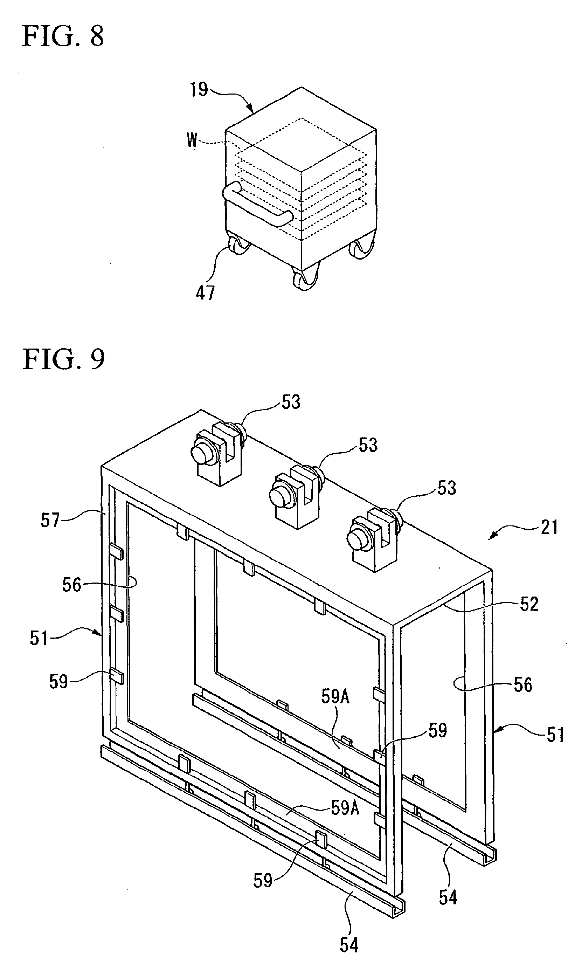

FIG. 2 is a schematic configuration view of a thin-film solar cell manufacturing apparatus. As shown in FIG. 2, the thin-film solar cell manufacturing apparatus 10 includes film forming chambers 11, loading-ejecting chambers 13 which can store substrates W, substrate replacement chambers 15 where the substrates W are attached to and detached from a carrier 21 (refer to FIG. 9), a substrate replacement robot (drive mechanism) 17 for attaching and detaching the substrates W to or from the carrier 21 (refer to FIG. 9), and substrate storage holders (conveying mechanisms) 19 which stores the substrates W. The film forming chambers 11 can simultaneously form bottom cells 104 (semiconductor layers) made of microcrystalline silicon on a plurality of substrates W, using a CVD method. The loading-ejecting chambers 13 can simultaneously store pre-processed substrates W1 carried into the film forming chambers 11 and post-processed substrates W2 carried out of the film forming chambers 11. The substrate replacement chambers 15 can attach and detach the pre-processed substrates W1, and the post-processed substrates W2. The substrate storage holder 19 stores the substrates W in order to convey the substrates W to the other processing processes. The film forming chamber 11, the loading-ejecting chamber 13, and the substrate replacement chamber 15 constitute a substrate film formation line 16. In addition, four substrate film formation lines 16 are provided in the present embodiment. Additionally, the substrate replacement robot 17 can move on rails 18 laid on a floor surface. Accordingly, transfer of the substrates W to all the substrate film formation lines 16 can be performed by one substrate replacement robot 17. Moreover, a process module 14 constituted by the film forming chamber 11 and the loading-ejecting chamber 13 are integrated together, and are formed with a size such that the module can be loaded into a truck.

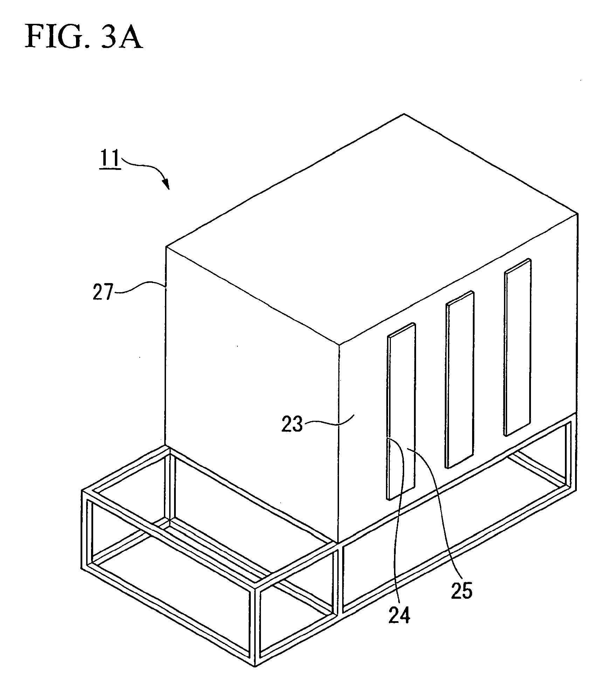

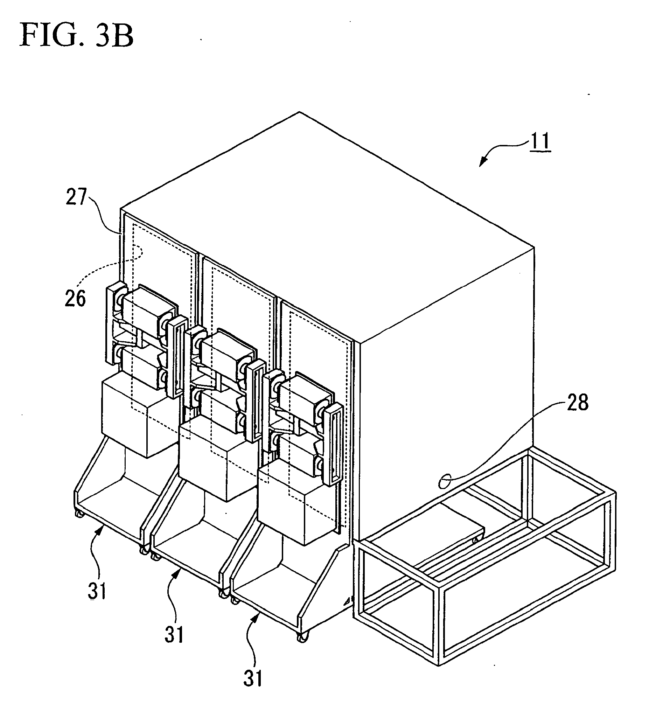

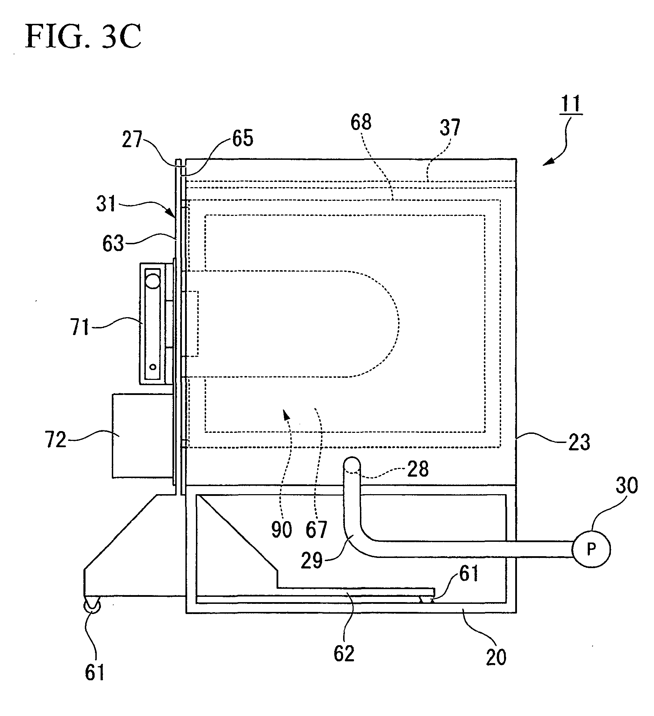

FIGS. 3A to 3C are views showing a schematic configuration of the film forming chamber 11. Among these drawings, FIG. 3A is a perspective view of the film forming chamber 11, FIG. 3B is a perspective view of the film forming chamber 11 as observed from an angle different from FIG. 3A, and FIG. 3C is a side view of the film forming chamber 11. As shown in FIGS. 3A and 3B, the film forming chamber 11 is formed in the shape of a box. The film forming chamber 11 has a side surface 23 connected to the loading-ejecting chamber 13. Three carrier transfer inlet and outlet ports 24 to which the carrier 21 on which the substrates W are mounted can pass through are formed the side surface 23. Additionally, shutters (first opening-closing parts) 25 which open and close the carrier transfer inlet and outlet ports 24 are provided at the carrier transfer inlet and outlet ports 24. When a shutter 25 is closed, the carrier transfer inlet and outlet port 24 is closed while securing airtightness. Three set of electrode units 31 for forming films on the substrates W are attached to a side surface 27 opposite to the side surface 23 of the film forming chamber 11. The electrode units 31 are configured to be attachable to and detachable from the film forming chamber 11. Specifically, as shown in FIG. 3B, the side surface 27 of the film forming chamber 11 is formed with three openings 26, and the electrode units 31 are installed so as to be attachable to and detachable from the openings 26. Additionally, a vacuuming pipe 29 for evacuating the space within the film forming chamber 11 is connected to a lateral lower portion 28 of the film forming chamber 11, and a vacuum pump 30 is provided at the vacuuming pipe 29.

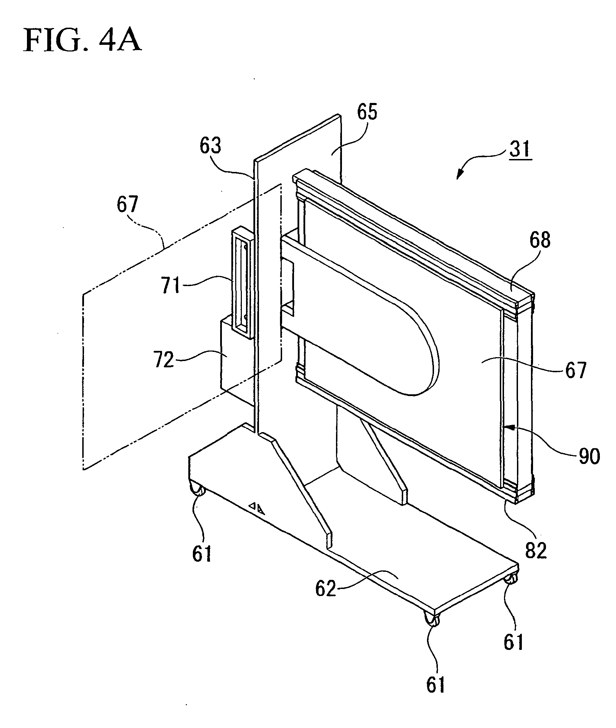

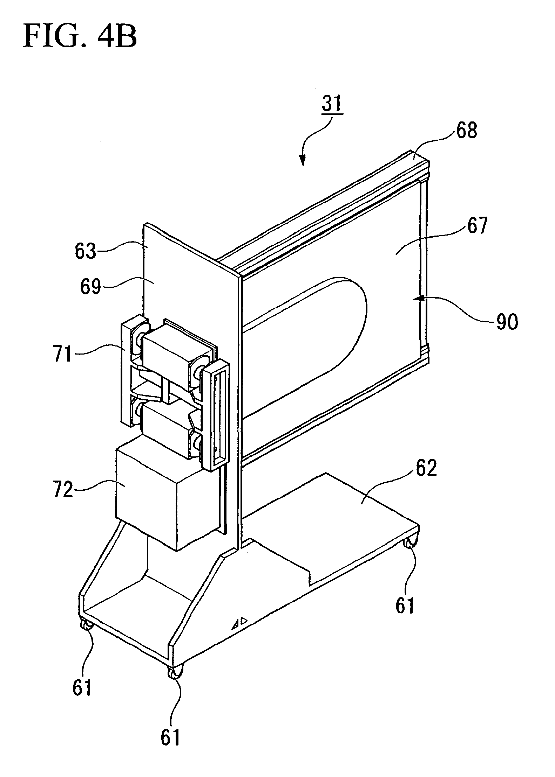

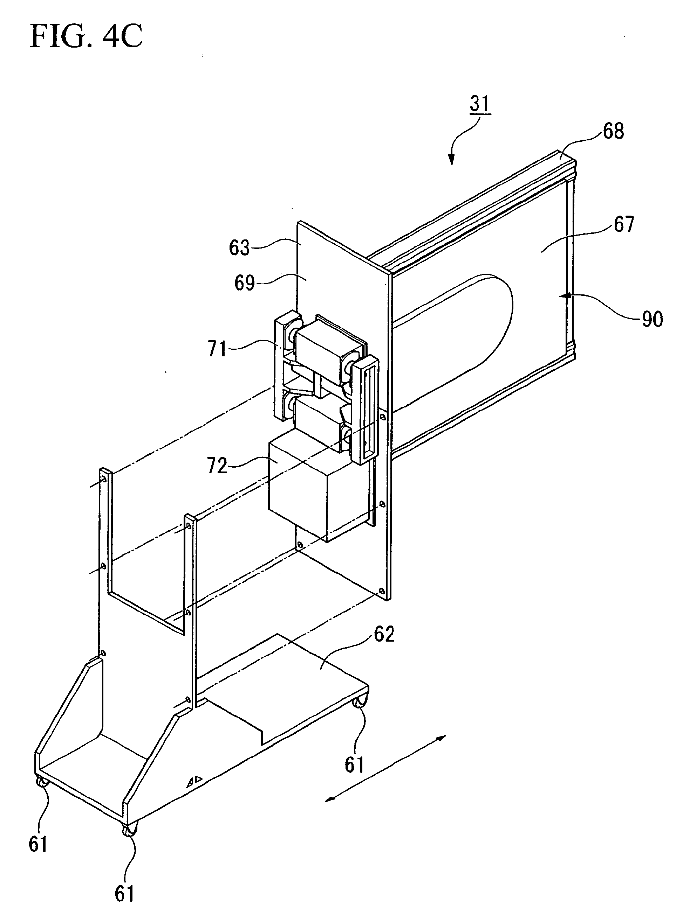

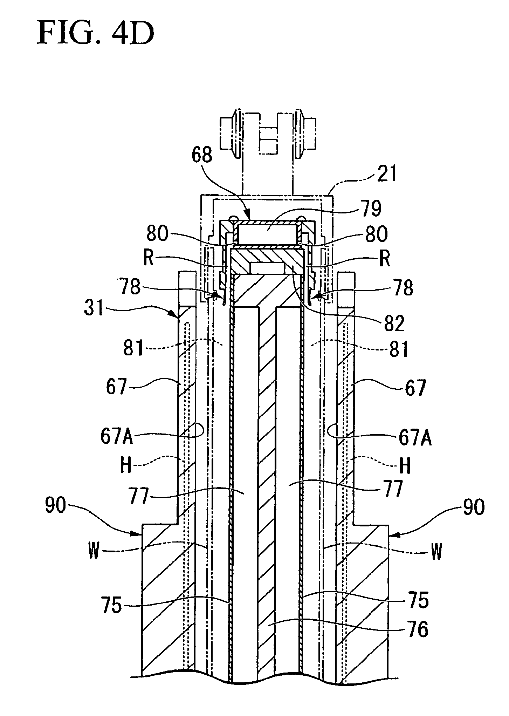

FIGS. 4A to 4D are views showing a schematic configuration of the electrode unit 31. Among these drawings, FIG. 4A is a perspective view of the electrode unit 31, FIG. 4B is a perspective view of the electrode unit 31 as observed from a different angle from FIG. 4A, FIG. 4C is a partially exploded perspective view of the electrode unit 31, and FIG. 4D is a partial sectional view of cathode units and an anode unit. As shown in FIGS. 4A to 4D, wheels 61 are provided at a lower portion of the electrode unit 31 and is the electrode unit 31 can be movable on the floor surface by the wheels 61. Additionally, on a bottom plate portion 62 to which the wheels 61 are attached, a side plate portion 63 is erected in the vertical direction. The side plate portion 63 has a size such that the side plate portion blocks the opening 26 of the side surface 27 of the film forming chamber 11.
As shown in FIG. 4C, the bottom plate portion 62 with the wheels 61 may be a truck structure which can be separated from and connected to the electrode unit 31. By adopting such a separable truck structure, the truck is separated after the electrode unit 31 is connected to the film forming chamber 11, and the separated truck can be used for the transfer of other electrode units 31 as a common truck.

That is, the side plate portion 63 forms a part of a wall surface of the film forming chamber 11. An anode unit 90 and a cathode unit 68 which are arranged on both sides of the substrate W when forming a film are formed at a first surface 65 (surface which faces the inside of the film forming chamber 11) of the side plate portion 63. In the electrode unit 31 of the present embodiment, anode units 90 are respectively arranged on both sides of the cathode unit 68 so as to separate from each other so that films can be simultaneously formed on two substrates W by one electrode unit 31. Accordingly, substrates W are respectively provided on both sides of the cathode unit 68 so as to face each other in a state where the substrates are substantially parallel to the direction of gravitational force, and two anode units 90 are arranged outside the respective substrates W in the thickness direction in a state where the anode units face the substrates W, respectively. In addition, the anode unit 90 is constituted by a plate-shaped anode 67, and a heater H built in the anode unit 90.

Additionally, a drive device 71 for driving the anode units 90, and a matching box 72 for feeding electric power to the cathode intermediate member 76 of the cathode unit 68 when forming a film are attached to the second surface 69 of the side plate portion 63. Moreover, a connecting portion (not shown) for piping which supplies the film forming gas to the cathode unit 68 are formed at the side plate portion 63.

A heater H is built in each anode unit 90, and the heater H is a temperature control unit which controls the temperature of the substrate W. Additionally, the two anode units 90 and 90 are movable in directions (horizontal directions) in which the anode units approach and separate from each other using the drive device 71 provided at the side plate portion 63, and the separation distance between the substrate W and the cathode unit 68 can be controlled. Specifically, when forming films on the substrates W, the two anode units 90 and 90 move toward the cathode unit 68, and abut on the substrates W, and further move in directions in which the anode units approach the cathode unit 68, thereby adjusting the separation distance between the substrates W and the cathode unit 68 to a desired distance. Thereafter, films are formed, and after the end of film forming, the anode units 90 and 90 move in the directions in which the anode units separate from each other, so that the substrates W can be easily taken out from the electrode unit 31.
Moreover, each anode unit 90 is attached to the drive device 71 via a hinge (not shown), and can be turned (opened) until the surface 67A of the anode unit 90 (anode 67) on the side of the cathode unit 68 becomes substantially parallel to the first surface 65 of the side plate portion 63, in a state in which the electrode unit 31 is pulled out of the film forming chamber 11. That is, as shown by a dotted line in FIG. 4A, the anode unit 90 can be turned by about 90° in plan view.

The cathode unit 68 has a shower plate 75 (cathode), a cathode intermediate member 76, a discharge duct 79, and a floating capacitance member 82.
Shower plates 75 formed with a plurality of small holes (not shown) are arranged on the surfaces of the cathode unit 68 which face the anode units 90 (anodes 67), so that the film forming gas can be jetted toward the substrates W. Moreover, the shower plates 75 and 75 are cathodes (high-frequency electrodes) connected to the matching box 72. The cathode intermediate member 76 connected to the matching box 72 is provided between the two shower plates 75 and 75. That is, the shower plates 75 are arranged on both sides of the cathode intermediate member 76 in a state where the shower plates are electrically connected to the cathode intermediate member 76. The cathode intermediate member 76 and the shower plates (cathodes) 75 are formed from electrical conductors, and high frequency is applied to the shower plates (cathodes) 75 via the cathode intermediate member 76. For this reason, voltages of the same potential and phase for generating plasma are applied to the two shower plates 75 and 75.
The cathode intermediate member 76 is connected to the matching box 72 by a wiring which is not shown. A space portion 77 is formed between the cathode intermediate member 76 and each shower plate 75, and the film forming gas is supplied to the space portion 77 from a gas supply apparatus (not shown). The space portions 77 are separated from each other by the cathode intermediate member 76, and are individually formed so as to correspond to the shower plates 75 and 75, so that the gases discharged from the respective shower plates 75 and 75 are controlled independently. That is, the space portion 77 has a function as a gas supply passage. In this embodiment, the space portions 77 are separately formed so as to correspond to the shower plates 75 and 75 respectively. Thus, the cathode unit 68 has two types of gas supply passages.

Additionally, a hollow discharge duct 79 is provided at a peripheral edge portion of the cathode unit 68 over its whole circumference. The discharge duct 79 is formed with a vacuuming port 80 for evacuating the film forming gas or reactive by-products (powder) in a film formation space 81. Specifically, the vacuuming port 80 is formed so as to face the film formation space 81 which is formed between the substrate W and the shower plate 75 when forming a film. A plurality of vacuuming ports 80 are formed along the peripheral edge portion of the cathode unit 68, and is configured so that evacuation can be made substantially equal over its whole circumference. Additionally, the discharge duct 79 has a surface which faces the inside of the film forming chamber 11 at the lower portion of the cathode unit 68, and the surface of the discharge duct which faces the inside of the film forming chamber 11 is formed with an opening (not shown) so that the evacuated film forming gas can be discharged into the film forming chamber 11. The gas discharged into the film forming chamber 11 is evacuated to the outside through the vacuuming pipe 29 provided at the lateral lower portion 28 of the film forming chamber 11. Additionally, the floating capacitance member 82 which has at least a dielectric body or laminating space (a dielectric body and/or laminating space) is provided between the discharge duct 79 and the cathode intermediate member 76. The discharge duct 79 is connected to an installation potential. The discharge duct 79 also functions as a shield frame for preventing abnormal electrical discharge from the cathode 75 and the cathode intermediate member 76.

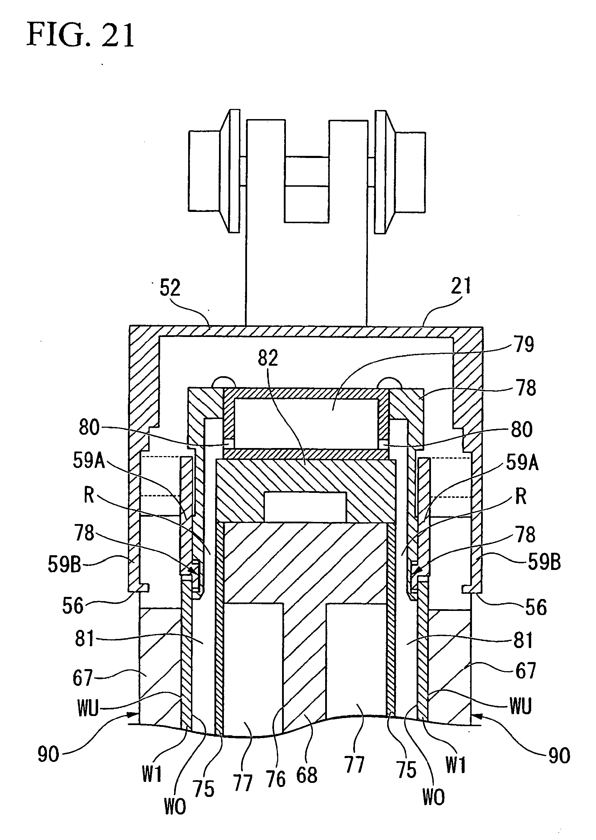

Moreover, masks 78 are provided at the peripheral edge portion of the cathode unit 68 so as to cover the part from the peripheral portion of the discharge duct 79 to the peripheral portion of the shower plate 75 (cathode). The masks 78 covers a holding piece 59A (refer to FIGS. 9 and 21) of a holding portion 59 (which will be described later) provided at the carrier 21, and forms a gas flow passage R for guiding the film forming gas or particles in the film formation space 81 to the discharge duct 79, integrally with the holding piece 59A when forming a film. That is, the gas flow passage R is formed between the carrier 21 (holding piece 59A) and the shower plate 75, and between the carrier 21 and the discharge duct 79.

Since such an electrode unit 31 is provided, in one electrode unit 31, two gaps are formed between the anode units 90 and the cathode unit 68 into which substrates W are inserted. Accordingly, films can be simultaneously formed on two substrates W by one electrode unit 31.

Additionally, the substrate W is disposed between each anode unit 90 and the cathode unit 68, and the anode unit 90 (anode 67) abuts on the substrate W, and is movable in order to adjust the separation distance between the substrate W and the cathode unit 68. Accordingly, when a thin-film Si-layer is formed on the substrate W by the plasma CVD method, the gap between the substrate W and the cathode unit 68 should be set to about 5 mm to 15 mm. However, the separation distance between the anode 67 and the cathode unit 68 can be adjusted before and after film formation by moving the anode 67. Accordingly, entrance and exit of the substrate W can be made easier. Additionally, when the substrate W enters and exits, it is possible to prevent the substrate W from being damaged by contacting with the anode 67 or the cathode unit 68. Moreover, by abutting (contacting) the anode 67 and the substrate W, the heat of the heater H can be effectively transferred to the substrate W when a film is formed while the substrate W is heated by the heater H. Accordingly, high-quality film forming can be performed.

Moreover, since the electrode unit 31 is configured to be attachable to and detachable from the film forming chamber 11, the periodical maintenance of removing the films deposited on the cathode unit 68 and anode units 90 of the electrode unit 31 can be easily performed. Additionally, if a spare electrode unit 31 is prepared, while the above electrode unit 31 is removed from the film forming chamber 11 for maintenance, the spare electrode unit 31 is attached instead, so that maintenance can be performed without stopping the manufacturing line. Accordingly, production efficiency can be improved. As a result, high throughput can be realized even when a semiconductor layer is formed on the substrate W at a low rate.

Referring back to FIG. 2, the transfer rails 37 are laid over the film forming chamber 11, the loading-ejecting chamber 13, and the substrate replacement chamber 15. The carrier 21 can be transferred between the film forming chamber 11 and the loading-ejecting chamber 13 and between the loading-ejecting chamber 13 and the substrate replacement chamber 15 by the transfer rails 37. In addition, the transfer rails 37 are separated between the film forming chamber 11 and the loading-ejecting chamber 13, and the carrier transfer inlet and outlet ports 24 can be sealed by closing the shutters 25.

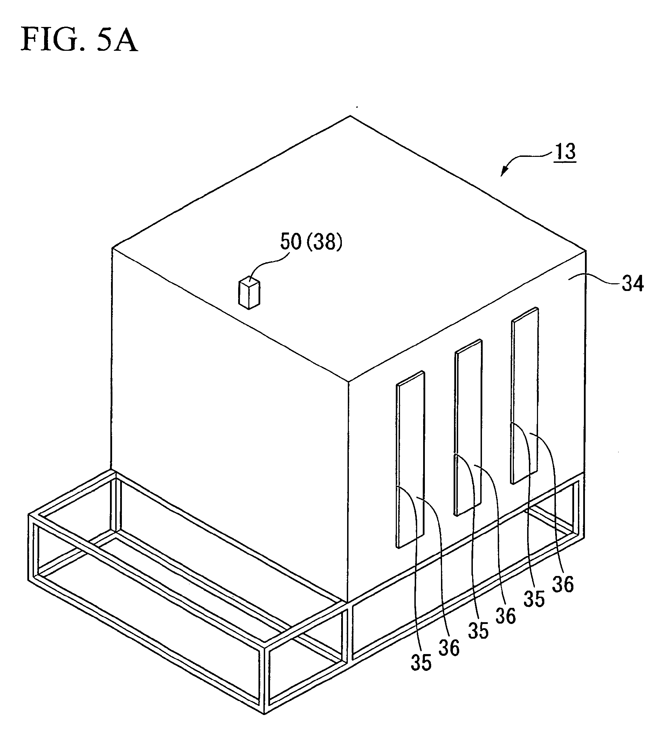

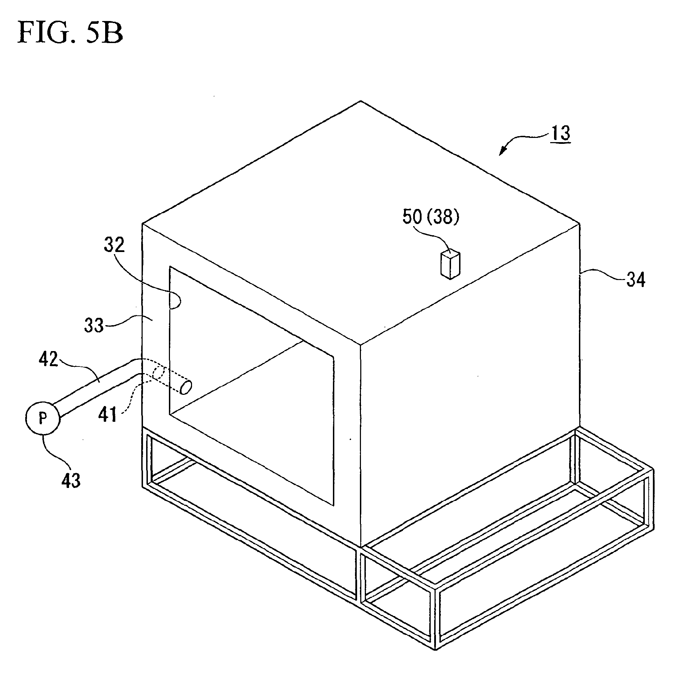

FIGS. 5A and 5B are views showing a schematic configuration of the loading-ejecting chamber 13, and FIG. 5A is a perspective view of the loading-ejecting chamber 13, and FIG. 5B is a perspective view as observed from an angle different from FIG. 5A. As shown in FIGS. 5A and 5B, the loading-ejecting chamber 13 is formed in the shape of a box. A side surface 33 of the loading-ejecting chamber 13 is connected to the side surface 23 of the film forming chamber 11 while securing airtightness. The side surface 33 of the loading-ejecting chamber 13 is formed with an opening 32 through which three carriers 21 can be inserted. A side surface 34 which is opposite to the side surface 33 of the loading-ejecting chamber 13 is connected to the substrate replacement chamber 15. The side surface 34 of the loading-ejecting chamber 13 is formed with three carrier transfer inlet and outlet ports 35 which allow the carrier 21 on which the substrates W are mounted to pass therethrough. Each carrier transfer inlet and outlet port 35 is provided with a shutter (second opening-closing part) 36 which can secure airtightness. In addition, the transfer rails 37 are separated between the loading-ejecting chamber 13 and the substrate replacement chamber 15, and the carrier transfer inlet and outlet ports 35 can be sealed by closing the shutters 36.

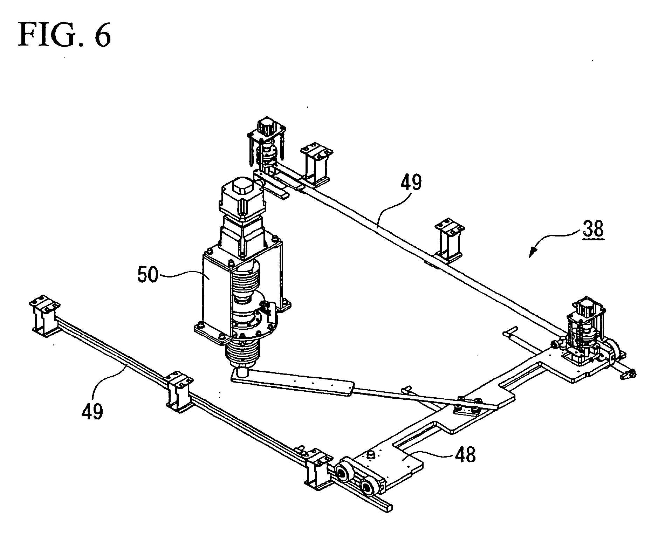

Additionally, the loading-ejecting chamber 13 is provided with a push-pull mechanism 38, called also a carrier transfer mechanism 38 for transferring the carrier 21 between the film forming chamber 11 and the loading-ejecting chamber 13 along the transfer rails 37. As shown in FIG. 6, the push-pull mechanism 38 includes a locking portion 48 for locking the carrier 21; a pair of guide members 49 provided at both ends of the locking portion 48, and disposed substantially parallel to the transfer rails 37; and a transfer apparatus 50 for moving the locking portion 48 along the guide members 49.

Moreover, a transfer mechanism (not shown) for transferring the carrier 21 by a predetermined distance in a direction substantially orthogonal to a direction in which the transfer rails 37 are laid in plan view is provided within the loading-ejecting chamber 13 in order to simultaneously store the pre-processed substrate W1 and the post-processed substrate W2. A vacuuming pipe 42 for evacuating the inside of the loading-ejecting chamber 13 is connected to a lateral lower portion 41 of the loading-ejecting chamber 13, and a vacuum pump 43 is provided at the vacuuming pipe 42.

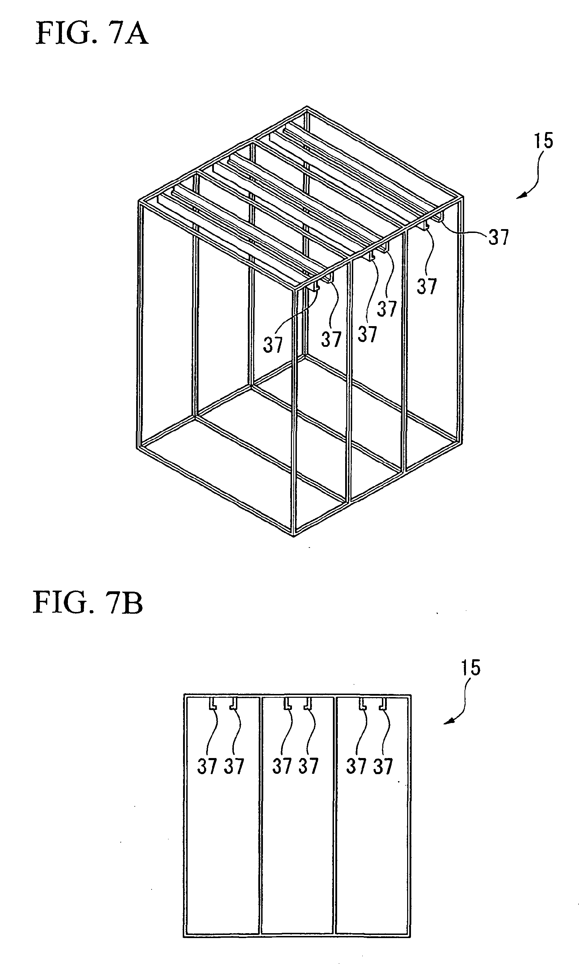

FIGS. 7A and 7B are views showing a schematic configuration of the substrate replacement chamber 15, FIG. 7A is a perspective view of the substrate replacement chamber 15, and FIG. 7B is a front view of the substrate replacement chamber 15. As shown in FIGS. 7A and 7B, the substrate replacement chamber 15 is formed in the shape of a frame, and is connected to the side surface 34 of the loading-ejecting chamber 13. In the substrate replacement chamber 15, the pre-processed substrates W1 can be attached to the carrier 21 disposed at the transfer rails 37, and the post-processed substrates W2 can be removed from the carrier 21. Three carriers 21 are arranged in parallel at the substrate replacement chamber 15.

The substrate replacement robot 17 (substrate conveying mechanism) has a drive arm 45 (refer to FIG. 2), and can suction the substrate W at the tip of the drive arm 45. Additionally, the drive arm 45 can be driven between the carrier 21 disposed at the substrate replacement chamber 15, and the substrate storage holder 19. That is, the drive arm 45 can remove the pre-processed substrate W1 from the substrate storage holder 19, and attach the pre-processed substrate W1 to the carrier (first carrier) 21 disposed at the substrate replacement chamber 15. Moreover, the drive arm 45 can remove the post-processed substrate W2 from the carrier (second carrier) 21 which has returned to the substrate replacement chamber 15, and can convey the post-processed substrate W2 to the substrate storage holder 19.
Additionally, the drive arm 45 has a rotating mechanism, can rotate a horizontal substrate W vertically and rotate a vertical substrate W horizontally.

FIG. 8 is a perspective view of the substrate storage holder 19. As shown in FIG. 8, the substrate storage holder 19 (storage mechanism) is formed in the shape of a box, and has a size such that the holder can store a plurality of substrates W. A plurality of substrates W can be stacked and stored in the up-and-down direction in a state where the surfaces to be film-formed of the substrates are made substantially parallel to the horizontal direction. Additionally, casters 47 are provided at a lower portion of the substrate storage holder 19 so as to allow for movement to the other processing apparatuses. In addition, a plurality of substrates W can be stored in the right-and-left direction in the substrate storage holder 19 in a state where the surfaces to be formed of the substrates W are substantially parallel to the direction of gravitational force.

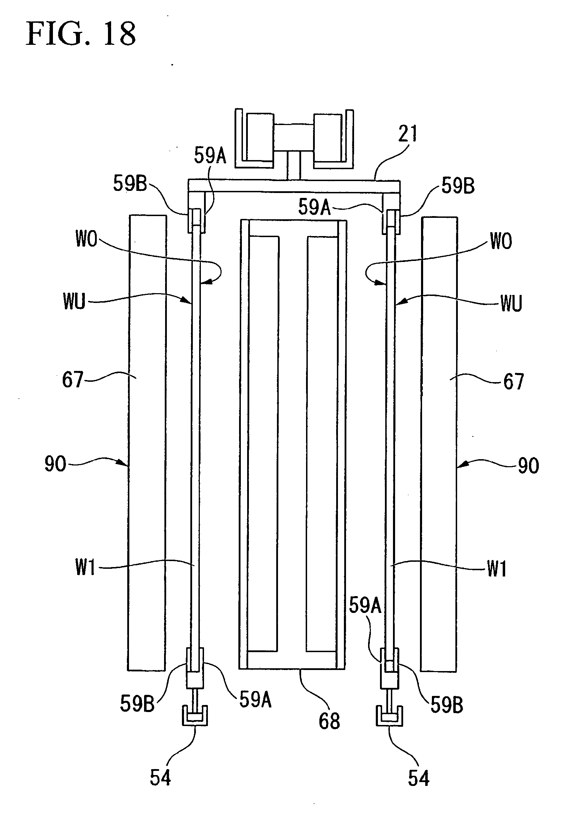

FIG. 9 is a perspective view of the carrier 21. As shown in FIG. 9, the carrier 21 is formed with two architrave-like frames 51 to which the substrates W can be attached. That is, two substrates W can be attached to one carrier 21. Two frames 51 and 51 are integrated together by a connection member 52 at the upper portions thereof. Additionally, a plurality of wheels 53 placed on the transfer rails 37 is provided above the connection member 52 so that the carrier 21 can be transferred as the wheels 53 roll on the transfer rails 37. Additionally, a lower portion of each frame 51 is provided with a frame holder 54 for suppressing the shaking of the substrate W when the carrier 21 is transferred. The tip of the frame holder 54 is fitted into a rail member 55 (refer to FIG. 18) with a concave cross-section provided on the bottoms of the film forming chamber 11, loading-ejecting chamber 13, and substrate replacement chamber 15. In addition, the rail members 55 are disposed in a direction along the transfer rails 37 in plan view. The substrate W can be more stably conveyed if the frame holder 54 is constituted by a plurality of rollers.

Each frame 51 has an opening 56, a peripheral edge portion 57, and a holding portion 59. The surface to be film-formed (front surface WO) of the substrate W is exposed to the opening 56 formed in the frame 51, and the holding portion 59 holds and fixes the substrate W from both sides at the peripheral edge portion 57 of the opening 56. A biasing force caused by a spring or the like acts on the holding portion 59 which holds the substrate W. Additionally, the holding portion 59 has holding pieces 59A and 59B which abut the front surface WO which is the surfaces to be formed of the substrate W and the rear surface WU (back surface) (refer to FIGS. 18 and 21). The separation distance between the holding pieces 59A and 59B is variable via the spring or the like. That is, the holding piece 59A can move along the directions in which the holding piece approaches and separates from the holding piece 59B according to the movement of the anode unit 90 (anode 67) (the details thereof will be described later). Here, one carrier 21 (one carrier which can hold a pair of (two) substrates) is attached onto one transfer rail 37. That is, three carriers 21 (which can hold three pairs of (six) substrates) are attached to one thin-film solar cell manufacturing apparatus 10.

Also, in the thin-film solar cell manufacturing apparatus 10 of the present embodiment, four substrate film formation lines 16 each including the above-described film forming chamber 11, loading-ejecting chamber 13, and substrate replacement chamber 15 are arranged. Accordingly, films can be substantially simultaneously formed on twenty four substrates W.

### < Manufacturing Method of Thin-film Solar Cell>

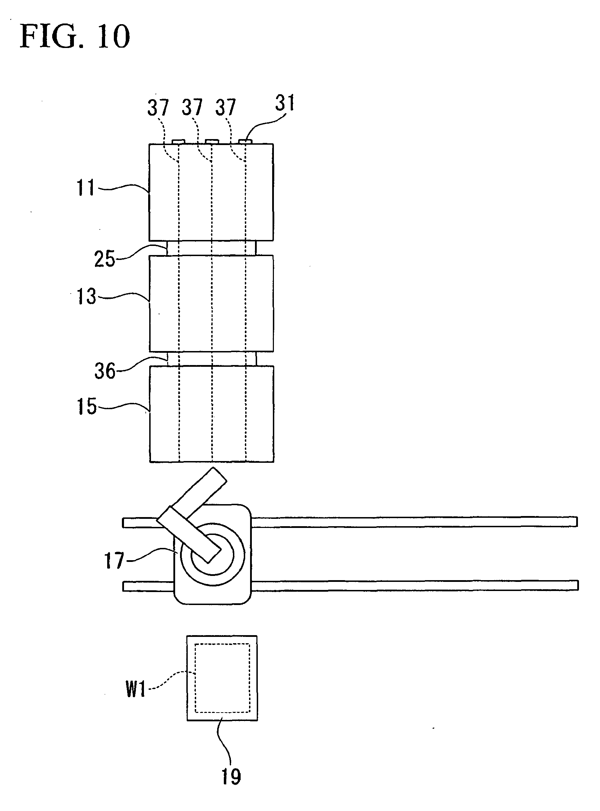

Next, a method for forming a film on a substrate W using the thin-film solar cell manufacturing apparatus 10 of the present embodiment will be described. In addition, although drawings of one substrate film formation line 16 are used in this description, the other three substrate film formation lines 16 also form films on substrates according to almost the same flow.
As shown in FIG. 10, the substrate storage holder 19 which stores a plurality of pre-processed substrates W1 is arranged at a predetermined position.

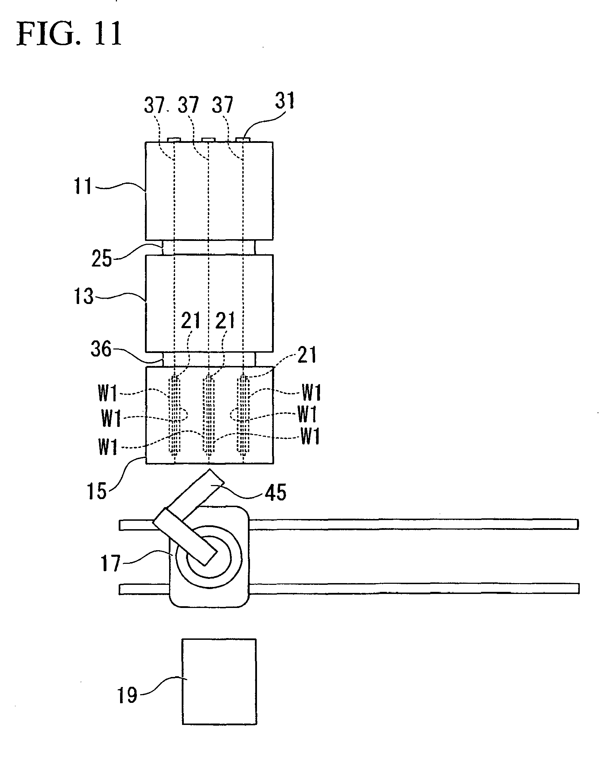

As shown in FIG. 11, the drive arm 45 of the substrate replacement robot 17 is operated to suction a rear surface of the surface to be film-formed of a substrate W within the substrate storage holder 19 and take one piece of the pre-processed substrate W1 out of the substrate storage holder 19, and attaches the pre-processed substrate W 1 to a carrier 21 installed in the substrate replacement chamber 15. The drive arm 45 has a rotating mechanism, and the pre-processed substrate W1 which has been arranged in the horizontal direction in the substrate storage holder 19 is attached to the carrier 21 after its orientation is changed to the vertical direction by this rotating mechanism. This operation is repeated once again to attach a second pre-processed substrate W1 to one carrier 21. Moreover, this operation is repeated to attach the pre-processed substrates W1 even to the remaining two carriers 21 installed in the substrate replacement chamber 15, respectively. That is, six pre-processed substrates W1 are attached to the carriers 21 in this step.

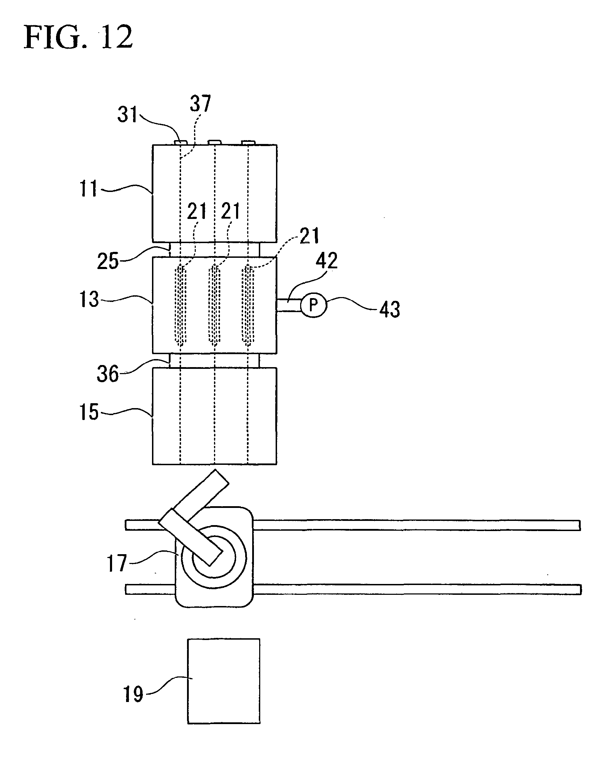

As shown in FIG. 12, the three carriers 21 to which the pre-processed substrates W1 are attached are substantially simultaneously transferred along the transfer rails 37, and are stored within the loading-ejecting chamber 13. After the carriers 21 are stored within the loading-ejecting chamber 13, the shutters 36 of the carrier transfer inlet and outlet ports 35 of the loading-ejecting chamber 13 are closed. Thereafter, the inside of the loading-ejecting chamber 13 is held in a vacuum state using the vacuum pump 43.

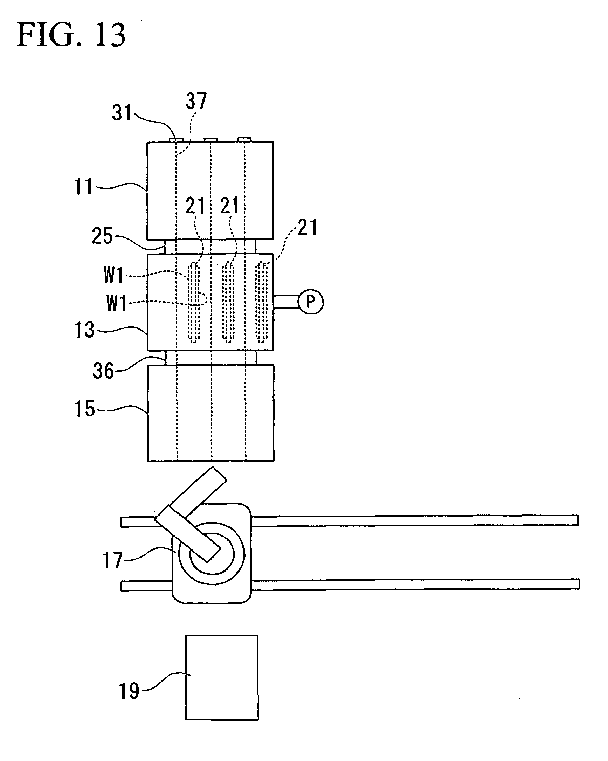

As shown in FIG. 13, the three carriers 21 are transferred using the transfer mechanism by a predetermined distance (half pitch), respectively, in a direction orthogonal to a direction in which the transfer rails 37 are laid in plan view. In addition, this predetermined distance is a distance where one carrier 21 is located between adjacent transfer rails 37 and 37.

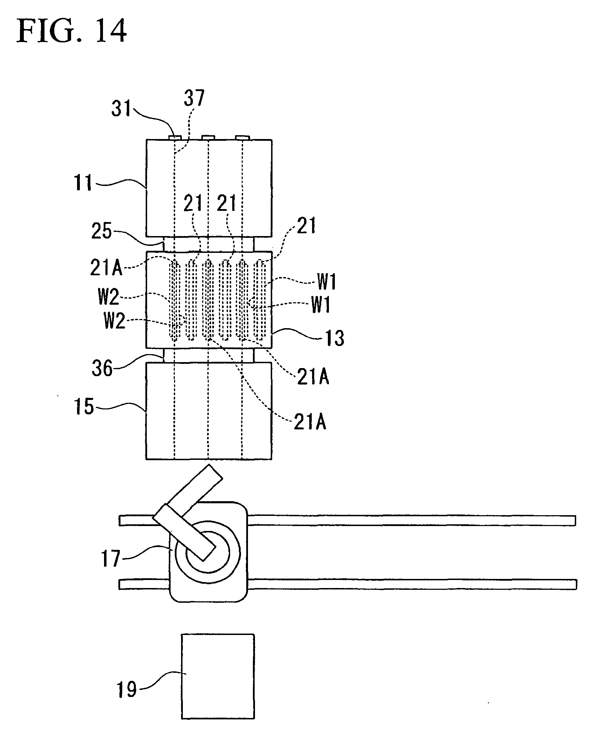

As shown in FIG. 14, the shutters 25 of the film forming chamber 11 are brought into an opened state, and the carriers 21A, to which the post-processed substrates W2 of which the film forming has been ended in the film forming chamber 11 are attached, are transferred to the loading-ejecting chamber 13, using the push-pull mechanism 38. At this time, the carriers 21 and the carriers 21 A are alternately arranged in parallel in plan view. By maintaining this state for a predetermined time, the heat which is accumulated in the post-processed substrates W2 is transferred to the pre-processed substrates W1. That is, the pre-processed substrates W1 are heated.

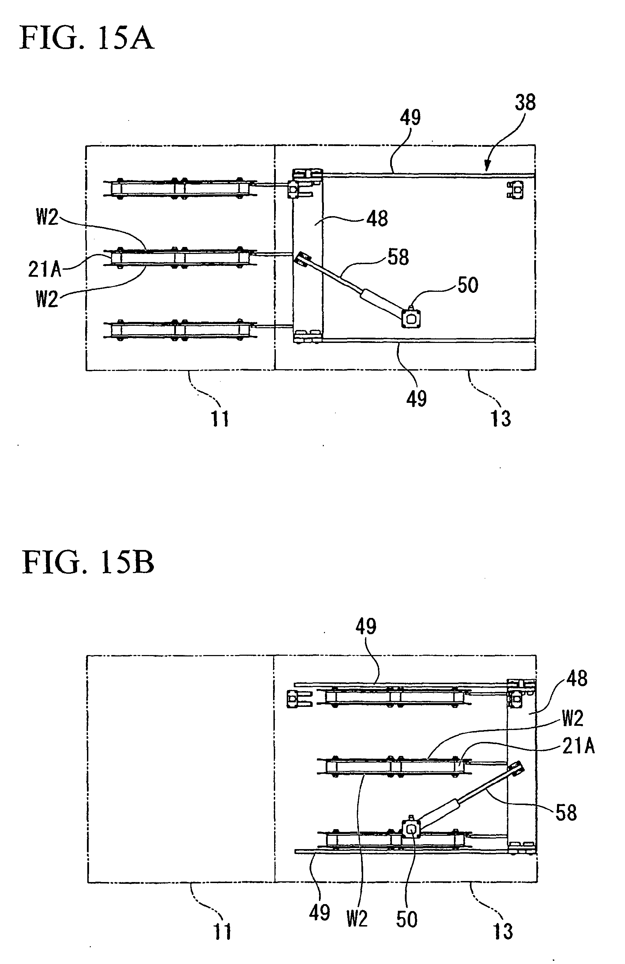

Here, the operation of the push-pull mechanism 38 will be described. In addition, the operation when the carriers 21 A located in the film forming chamber 11 are transferred into the loading-ejecting chamber 13 will be described here.
As shown in FIG. 15A, the carriers 21A to which the post-processed substrates W2 are attached are locked to the locking portion 48 of the push-pull mechanism 38. Then, the transfer arm 58 of the transfer apparatus 50 which are attached to the locking portion 48 is swung. At this time, the length of the transfer arm 58 is variable. Then, the locking portion 48 to which the carriers 21A have been locked is guided by the guide members 49, and is moved along the guide members 49. Thereby, as shown in FIG. 15B, the carriers 21A locked to the locking portion 48 are transferred into the loading-ejecting chamber 13. That is, the carriers 21A are transferred to the loading-ejecting chamber 13 from the film forming chamber 11. By adopting such a configuration, it becomes unnecessary to install a drive source for driving the carriers 21 A within the film forming chamber 11. In addition, the carriers 21 within the loading-ejecting chamber 13 are transferred into the film forming chamber 11 by performing an operation which is opposite to the above described operation.

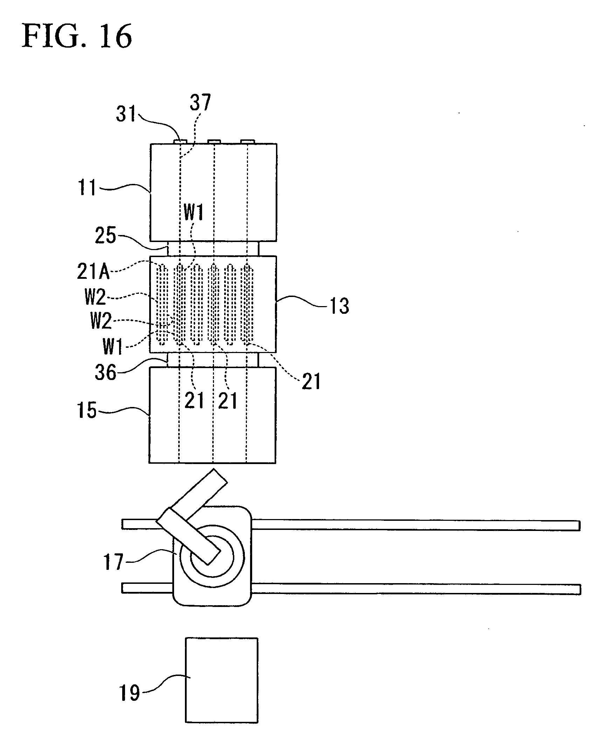

As shown in FIG. 16, the carriers 21 and the carriers 21 A are transferred in a direction orthogonal to the transfer rails 37 by the transfer mechanism, and the carriers 21 holding the pre-processed substrates W1 are transferred to positions along the transfer rails 37.

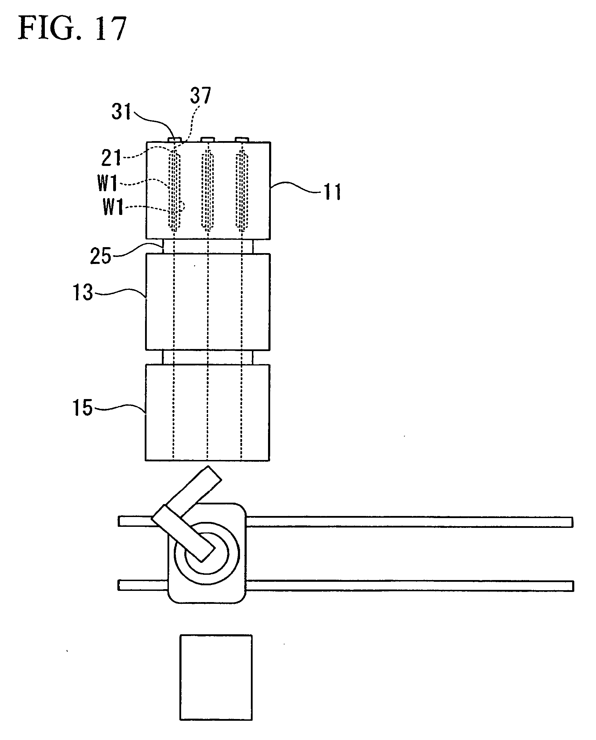

As shown in FIG. 17, the carriers 21 holding the pre-processed substrates W1 are transferred to the film forming chamber 11, using the push-pull mechanism 38, and the shutters 25 are brought into a closed state after the completion of the transfer. In addition, a vacuum state is held in the film forming chamber 11. At this time, the pre-processed substrates W1 attached to the carrier 21 are inserted into between the anode units 90 and the cathode unit 68 in a state where the front surfaces WO thereof run along the vertical direction substantially parallel to the direction of gravitational force within the film forming chamber 11 (refer to FIG. 18).

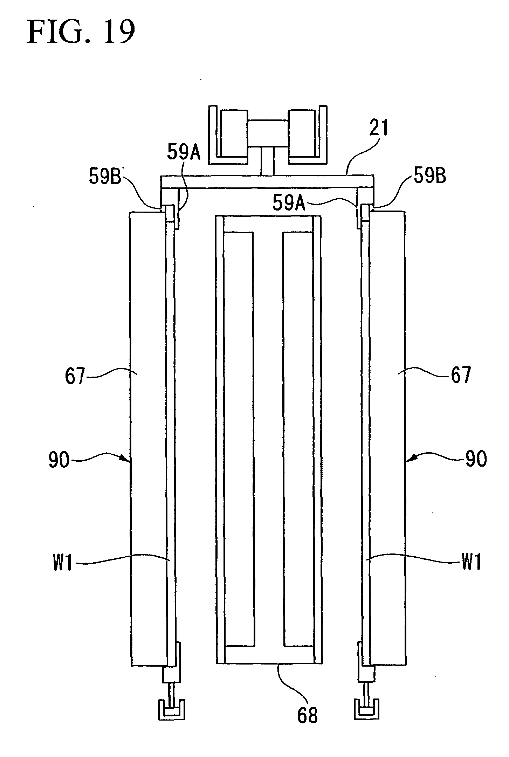

As shown in FIGS. 18 and 19, the anode units 90 (anodes 67) and the rear surfaces WU of the pre-processed substrates W1 are made to abut on each other by moving the two anode units 90 of the electrode unit 31 in a direction in which the anode units approach each other using the drive device 71.

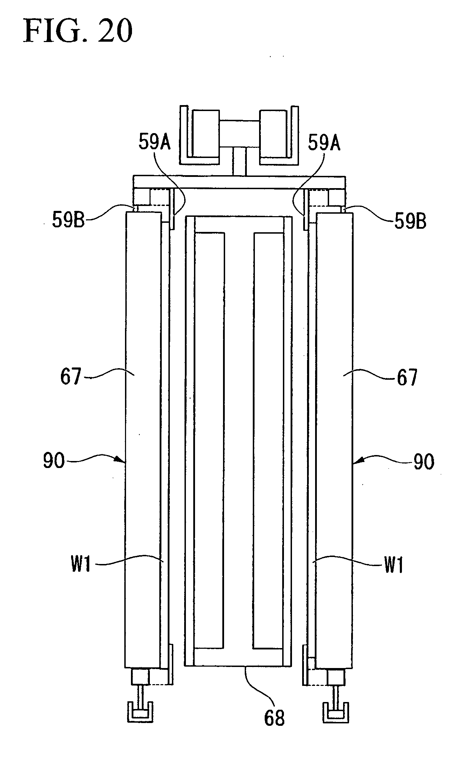

As shown in FIG. 20, when the drive device 71 is further driven, the pre-processed substrates W1 move toward the cathode unit 68 so as to be pushed by the anodes 67. Then, the pre-processed substrates W1 are moved until the gap between the pre-processed substrate W1 and the shower plate 75 of the cathode unit 68 reaches a predetermined distance (film forming distance). In addition, the gap (film forming distance) between the pre-processed substrate W1 and the shower plate 75 of the cathode unit 68 is 5 mm to 15 mm, and is, for example, about 5 mm.

At this time, the holding piece 59A of the holding portion 59 of the carrier 21 which abuts on the front surface WO of the pre-processed substrate W1 is displaced along with the movement of the pre-processed substrate W1 (of the anode unit 90). In addition, when the anode unit 90 has moved toward the direction away from the cathode unit 68, the restoring force of the spring or the like acts on the holding piece 59A so that this holding piece is displaced toward the holding piece 59B. The pre-processed substrate W1 at this time is held by the anode 67 and the holding piece 59A.

As shown in FIG 21, when the pre-processed substrate W1 moves toward the cathode unit 68, the holding piece 59A abuts on the mask 78, and the movement of the anode unit 90 stops at this time.
Here, as shown in FIG. 21, the mask 78 is formed so as to cover the surface of the holding piece 59A and the outer-edge portion of the substrate W and come into close contact with the holding piece 59A or the outer-edge portion of the substrate W. That is, a mating surface between the mask 78 and the holding piece 59A or a mating surface between the mask 78 and the outer-edge portion of the substrate W has a function as a seal surface so that the film forming gas does not leak out from between the mask 78 and the holding piece 59A or between the mask 78 and the outer-edge portion of the substrate W to anode 67 side. This limits the range where the film forming gas spreads, and can keep a film from being formed in an unnecessary range. Thereby, the cleaning range can be narrowed, the cleaning frequency can be reduced, and the operating rate of the apparatus is improved.
Additionally, since the movement of the pre-processed substrate W1 stops when the outer-edge portion of the substrate W abuts on the mask 78, the flow passage height of the gas flow passage R, which is formed by the gap between the mask 78 and the shower plate 75 and between the mask 78 and the discharge duct 79, in the thickness direction is set so that the gap between the pre-processed substrate W1 and the cathode unit 68 reaches a predetermined distance.
As another aspect, the distance between the substrate W and the shower plate 75 (cathode) can also be arbitrarily changed by the stroke of the drive mechanism 71 by attaching the mask to the discharge duct 79 via an elastic body. In the above aspect, a case where the mask 78 and the substrate W abut on each other has been described above. However, the mask 78 and the substrate W may be arranged so as to leave a minute gap which limits the passage of the film forming gas.

In such a state, the film forming gas is jetted from the shower plate 75 of the cathode unit 68, and the matching box 72 is started to apply a voltage to the shower plate 75 (cathode) of the cathode unit 68, thereby generating plasma in the film formation space 81 to form a film on the front surface WO of the pre-processed substrate W1. At this time, the pre-processed substrate W1 is heated to a desired temperature by the heater H built in the anode 67.

Here, the anode unit 90 stops heating when the pre-processed substrate W1 reaches a desired temperature. However, plasma is generated within the film formation space 81 by applying a voltage to the cathode unit 68. Even if the heating of the anode unit 90 is stopped, there is a possibility that the temperature of the pre-processed substrate W1 may rise higher than a desired temperature due to the heat input from the plasma with the passage of time. In this case, the anode unit 90 can also be made to function as a radiator plate for cooling the pre-processed substrate W1 where the temperature has risen excessively. Accordingly, the temperature of the pre-processed substrate W1 is maintained at a desired temperature irrespective of the passage of the film formation processing time.
In addition, when a plurality of layers are formed through one film formation processing process, a film forming gas material to be supplied can be changed every predetermined time.

During film forming and after film forming, the gas or particles in the film formation space 81 are evacuated from the vacuuming ports 80 formed in the peripheral edge portion of the cathode unit 68. Along with this, the evacuated gas passes through the opening (opening formed in the surface of the discharge duct 79 which faces the inside of the film forming chamber 11 at the lower portion of the cathode unit 68) from the discharge duct 79 at the peripheral edge portion of the cathode unit 68 via the gas flow passage R, and flows to the outside from the vacuuming pipe 29 provided at the lateral lower portion 28 of the film forming chamber 11. In addition, the reactive by-products (powder) generated when forming a film can be collected and disposed of when being made to adhere to the inner wall surface of the discharge duct 79. Since the same processing as the above-described processing is performed in all the electrode units 31 within the film forming chamber 11, film forming can be simultaneously performed on six substrates W.

When the film forming is ended, the two anode units 90 are moved in directions away from each other by the drive device 71, and the post-processed substrates W2 and the frames 51 (holding pieces 59A) are returned to their original positions (refer to FIGS. 19 and 21). Moreover, by moving the anode units 90 in directions away from each other, the post-processed substrates W2 and the anode units 90 are separated from each other (refer to FIG. 18).

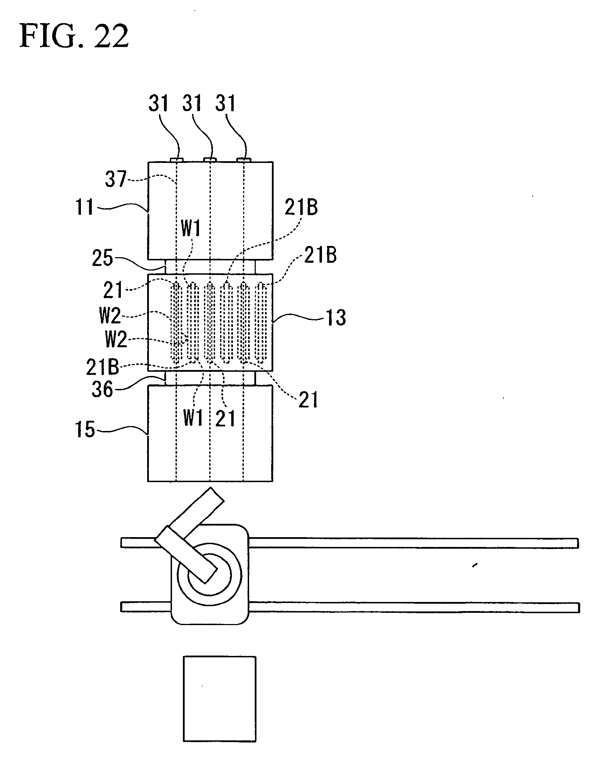

As shown in FIG. 22, the shutters 25 of the film forming chamber 11 are brought into an opened state, and the carriers 21 are transferred to the loading-ejecting chamber 13, using the push-pull mechanism 38. At this time, the loading-ejecting chamber 13 is evacuated, and the carrier 21B to which the pre-processed substrates W1 to be formed next are already located. Then, the heat accumulated in the post-processed substrates W2 is transferred to the pre-processed substrates W1 within the loading-ejecting chamber 13, and the temperature of the post-processed substrates W2 is lowered.

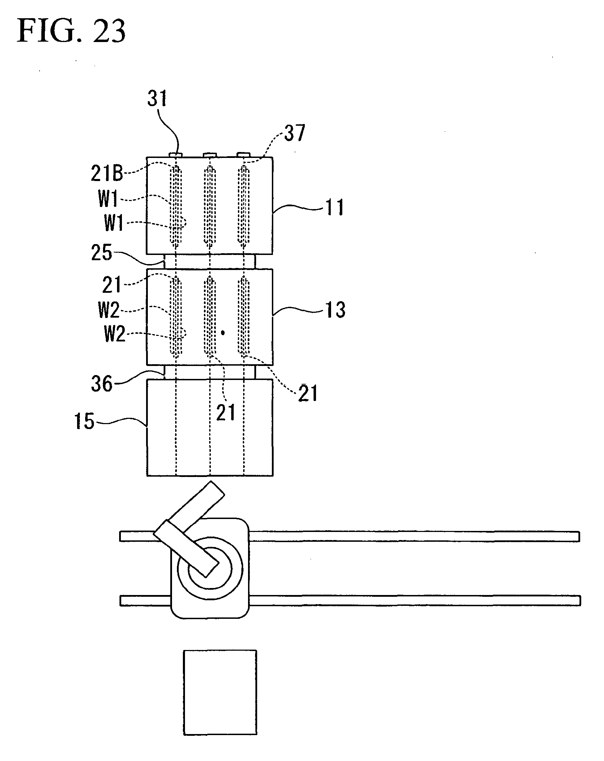

As shown in FIG. 23, after the carrier 21B is transferred into the film forming chamber 11, the carrier 21 is returned to a position arranged on the transfer rails 37 by the transfer mechanism.

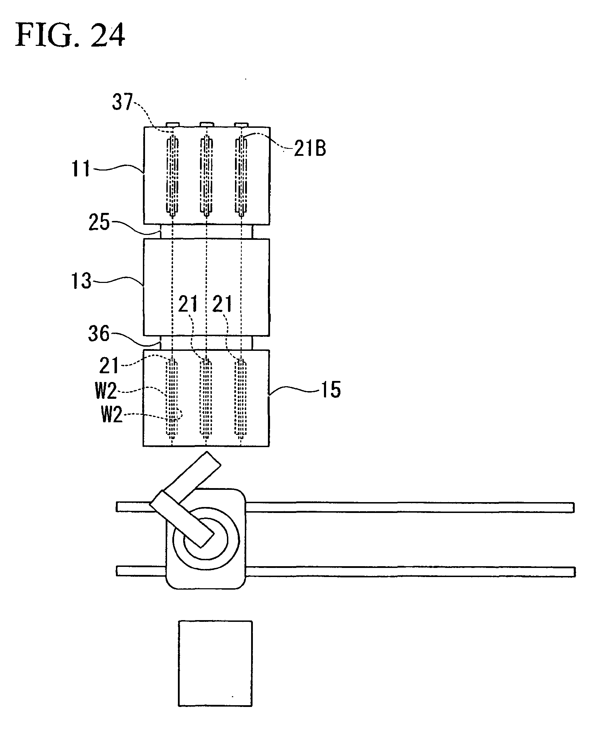

As shown in FIG. 24, after the shutters 25 are brought into a closed state, and the temperature of the post-processed substrates W2 is lowered to a predetermined temperature, the shutters 36 are brought into an opened state, and the carriers 21 are transferred to the substrate replacement chamber 15.

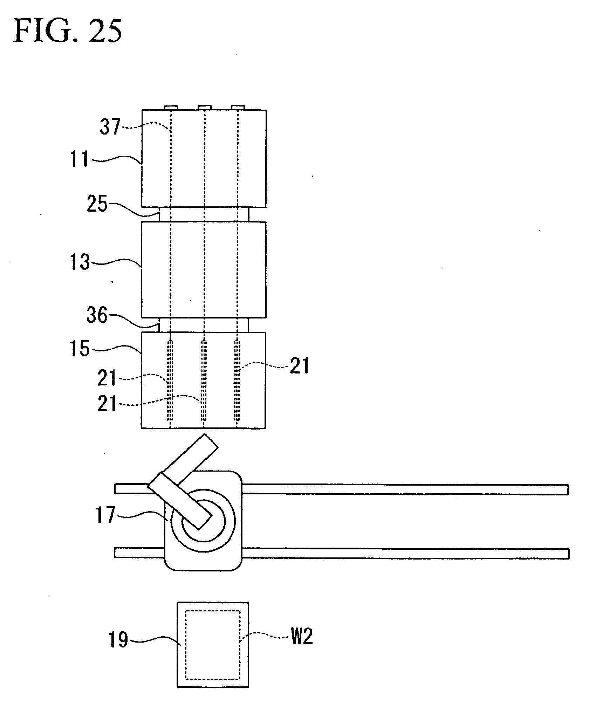

As shown in FIG. 25, the post-processed substrate W2 is removed from the carrier 21 by the substrate replacement robot 17 in the substrate replacement chamber 15, and the post-processed substrate W2 is conveyed to the substrate storage holder 19. When removal of all the post-processed substrates W2 is completed, the processing is ended by moving the substrate storage holder 19 to a place for the following process.

According to the thin-film solar cell manufacturing apparatus 10 of the present embodiment, the loading-ejecting chamber 13 is provided with a push-pull mechanism 38, and the carrier 21 can be transferred on the transfer rails 37 laid between the film forming chamber 11 and the loading-ejecting chamber 13 using the push-pull mechanism 38. Hence, in the film forming chamber 11, only the transfer rails 37 are provided without a drive source for transferring the carrier 21. Accordingly, it is not necessary to perform maintenance on a drive source within the film forming chamber 11 unlike a conventional technique, and the maintenance frequency of the film forming chamber 11 can be reduced to improve production efficiency.

Additionally, since the substrate replacement robot 17 suctions the rear surface WU of the surface to be film-formed of a substrate W and moves the substrate W between the substrate replacement chamber 15 and the substrate storage holder 19, particularly when moving the post-processed substrate W2, it is possible to avoid that the substrate replacement robot 17 contacts a film forming area (surface to be film-formed). Accordingly, the quality of the surface to be film-formed can be reliably maintained when the post-processed substrate W2 is conveyed, and the yield can be improved.

Additionally, in the present embodiment, transfer and film formation processing within the thin-film solar cell manufacturing apparatus 10 are performed in a state where the substrate W is erected in the vertical direction (state where the substrate W is arranged so that the surface to be film-formed thereof becomes substantially parallel to the direction of gravitational force). As a result, the area required for a substrate W to move within the thin-film solar cell manufacturing apparatus 10 can be reduced to miniaturize the apparatus, and a larger number of apparatuses can be arranged in the same installation area as a conventional technique. Accordingly, the number of substrates W on which films are simultaneously formed can be increased, and productivity can be improved. Additionally, when a film is formed on a substrate W in a state where the substrate is erected in the vertical direction, particles generated when forming a film can be kept from depositing on the film formation surface of the substrate W. Accordingly, a high-quality semiconductor layer can be formed on the substrate W.

Additionally, since one carrier 21 can hold a plurality of (two) substrates W, films can be simultaneously formed on a plurality of substrates W in one carrier 21, and productivity can be further improved. Moreover, since the push-pull mechanism 38 can simultaneously convey a plurality of carriers 21, the processing rate can be further raised.

Moreover, the substrate W can be arranged in the substrate storage holder 19 so that the surface to be film-formed thereof becomes substantially horizontal, and the substrate W can be arranged in the carrier 21 so that the surface to be film-formed thereof becomes substantially parallel to the direction of gravitational force. Accordingly, when the substrate W is stored in the substrate storage holder 19 and conveyed to other processing processes, film forming quality can be maintained during movement by making the surface to be film-formed of the substrate W substantially parallel to the horizontal direction. Additionally, the area required for the substrate W to move within the apparatus can be reduced by making the surface to be film-formed of the substrate W substantially parallel to the direction of gravitational force when the substrate W is attached to the carrier 21. Accordingly, production efficiency can be improved.

Moreover, since a plurality of process modules 14 in which the film forming chamber 11 and the loading-ejecting chamber 13 are connected to each other is arranged in parallel, the number of substrates W on which films can be simultaneously formed can be further increased, and even when the semiconductor layer is formed on a substrate W at a low rate, a high throughput can be realized. Additionally, the installation time (building time of a manufacturing line) of the apparatus when the manufacturing line is built in a factory or the like can be shortened by integrating the apparatus as the process module 14. Moreover, when maintenance of the film forming chamber 11 is performed, it becomes unnecessary to stop the whole manufacturing line by performing the maintenance for every process module 14. Accordingly, a decrease in production efficiency during maintenance can be suppressed to a minimum.

In addition, the evacuation process in a series of substrate film forming processes of the loading-ejecting chamber 13 can be reduced by simultaneously storing the post-processed substrate W2 and the pre-processed substrate W1 in the loading-ejecting chamber 13. Accordingly, productivity can be improved. Additionally, when the post-processed substrate W2 and the pre-processed substrate W 1 are simultaneously stored in the loading-ejecting chamber 13, the heat accumulated in the post-processed substrate W2 is transferred to the pre-processed substrate W1, whereby heat exchange is performed. Thereby, a heating process which is usually performed subsequent to the pre-processed substrate W1 being stored in the film forming chamber 11, and a cooling process which is usually performed prior to the post-processed substrate W2 being carried out of the loading-ejecting chamber 13 can be omitted. As a result, productivity can be improved, and manufacturing costs can be reduced because devices used for conventional heating and cooling processes can be omitted.

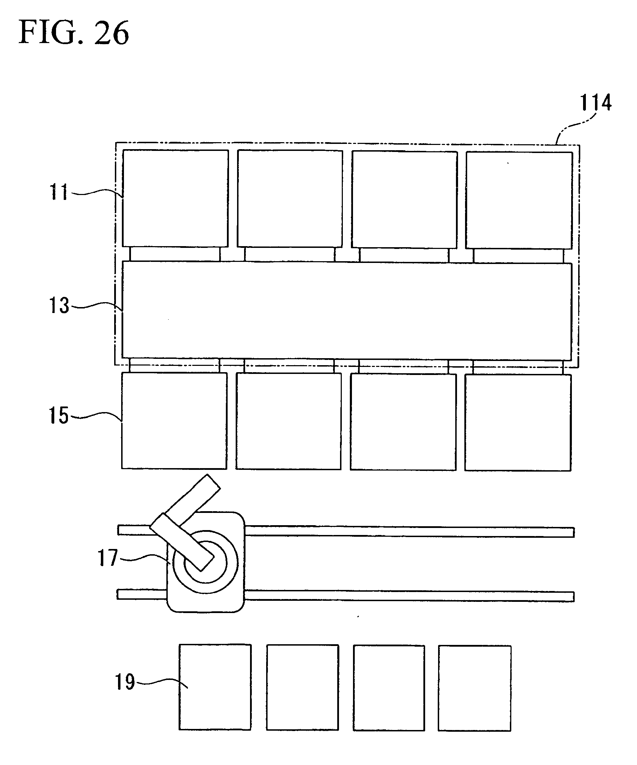

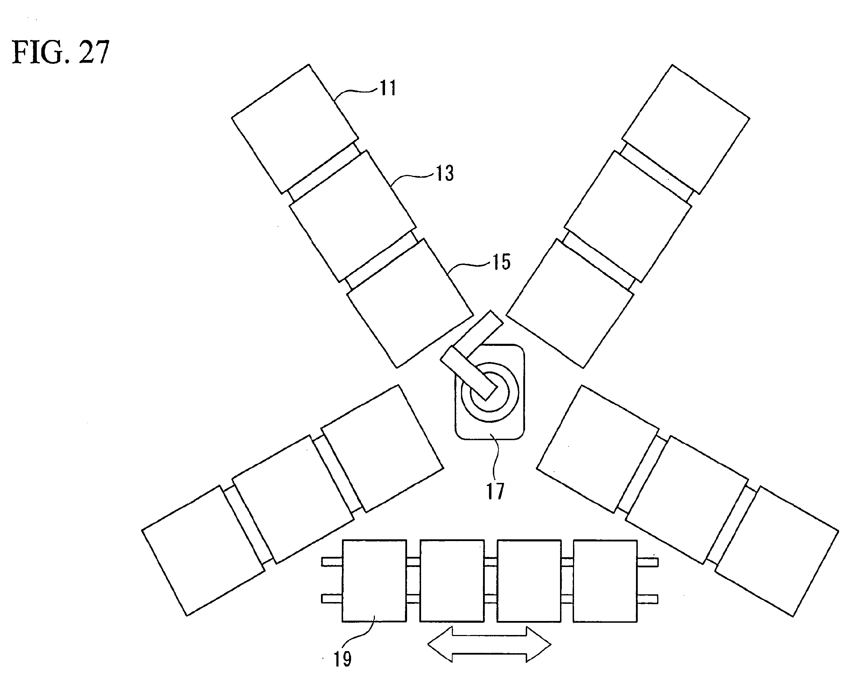

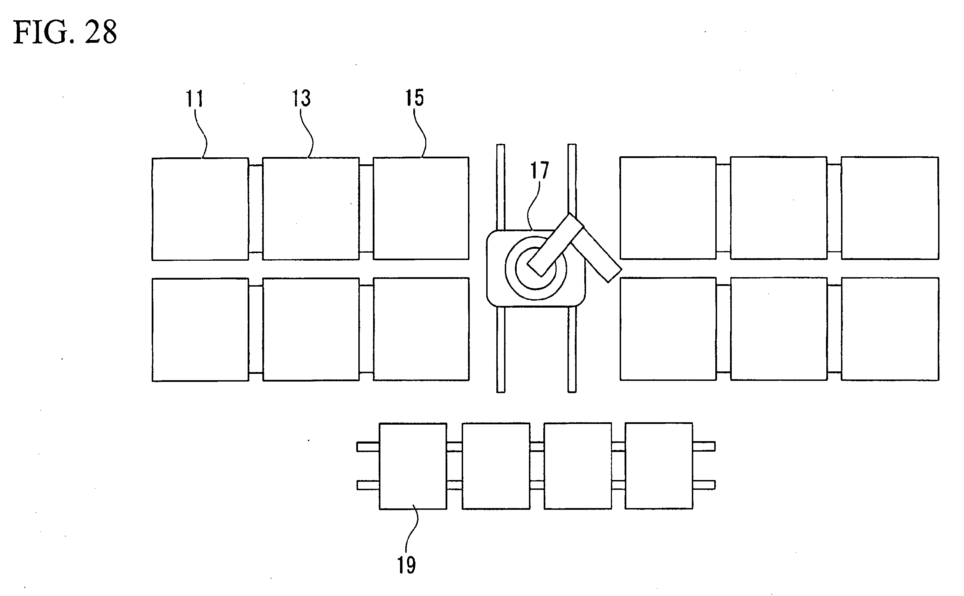

In addition, it should be understood that the technical scope of the present invention is not limited to the above-described embodiment, but that various modifications of the above-described embodiment may be made without departing from the scope of the invention. That is, the specific shapes and configurations as mentioned in the embodiment are merely examples, and can be appropriately changed. For example, although the case where one loading-ejecting chamber is connected to one film forming chamber has been described in the present embodiment, as shown in FIG. 26, a process module 114 in which a plurality of film forming chambers 11 is arranged in parallel and is connected to one big loading-ejecting chamber 13 may be provided so that a carrier can be transferred within the loading-ejecting chamber 13. By adopting such a configuration, a substrate attached to a carrier can be moved within the loading-ejecting chamber. Therefore, different film forming materials can be supplied in the film forming chambers, respectively. Thereby, a plurality of layers with different film forming materials can be more efficiently formed on a substrate.
Additionally, the thin-film solar cell manufacturing apparatus may be arranged as shown in FIG. 27. In this example, modules each including the film forming chamber 11, the loading-ejecting chamber 13, and the substrate replacement chamber 15 are radially installed at the substrate element robot 17. By adopting such a configuration, the time for which the substrate replacement robot 17 moves on the rails can be eliminated. That is, the operating time of the substrate replacement robot 17 can be shortened, and tact time can be shortened.
Moreover, the thin-film solar cell manufacturing apparatus may be arranged as shown in FIG. 28. In this example, modules each including the film forming chamber 11, the loading-ejecting chamber 13, and the substrate replacement chamber 15 are installed on both sides of the substrate replacement robot 17. By adopting such a configuration, space can be saved, and the operating time of the substrate replacement robot 17 can be shortened.
Although the present embodiment is configured so that one substrate replacement robot 17 is arranged to perform attachment and detachment of the substrate W, two substrate replacement robots 17 may be arranged, one substrate replacement robot 17 may be used only for the attachment of the substrate W, and the other substrate replacement robot 17 may be used only for the removal of the substrate W. Additionally, a configuration may be adopted in which two drive arms are provided in one substrate replacement robot 17, and two substrates W are simultaneously attached and removed.

### [Industrial Applicability]

According to the embodiment of the present invention, in the film forming chamber, only the transfer rails are provided without a drive source for transferring the carrier. Accordingly, it is not necessary to perform maintenance on a drive source within the film forming chamber unlike a conventional technique, and the maintenance frequency of the film forming chamber can be reduced to improve production efficiency.

### [Description of the Reference Numerals]

- 10:: THIN-FILM SOLAR CELL MANUFACTURING APPARATUS
- 11:: FILM FORMING CHAMBER
- 13:: LOADING-EJECTING CHAMBER
- 14:: SUBSTRATE FILM FORMATION MODULE
- 15:: SUBSTRATE REPLACEMENT CHAMBER
- 17:: SUBSTRATE REPLACEMENT ROBOT (DRIVE MECHANISM)
- 19:: SUBSTRATE STORAGE HOLDER (CONVEYING MECHANISM)
- 21:: CARRIER
- 25:: SHUTTER (FIRST OPENING-CLOSING PART)
- 36:: SHUTTER (SECOND OPENING-CLOSING PART)
- 37:: TRANSFER RAIL
- 38:: PUSH-PULL MECHANISM (TRANSFER MECHANISM)
- 104:: BOTTOM CELL (FILM)
- W:: SUBSTRATE
- W1:: PRE-PROCESSED SUBSTRATE
- W2:: POST-PROCESSED SUBSTRATE

## Claims

1. A thin-film solar cell manufacturing apparatus (10) comprising:
a film forming chamber (11) that is evacuated to a reduced pressure and forms a film on a substrate using a CVD method;
a loading-ejecting chamber (13) that is connected to the film forming chamber (11) via a first opening-closing part (25) and that is switchable between atmospheric pressure and reduced pressure;
a transfer rail (37) that is laid at the film forming chamber (11) and the loading-ejecting chamber (13);
a carrier (21, 21A) that moves along the transfer rail (37) and holds the substrate in a vertical posture where a surface to be film-formed of the substrate is parallel to a direction of gravitational force; and
a carrier transfer mechanism (38) that transfers the carrier (21, 21A),
wherein the carrier transfer mechanism (38) is provided in the loading-ejecting chamber (13),
wherein the carrier transfer mechanism (38) includes:
a locking portion (48) that locks the carrier;
a pair of guide members (49) that are provided at both ends of the locking portion (48), and are disposed parallel to the transfer rail (37);
a transfer apparatus (50) that moves the locking portion (48) along the guide members (49), and
a transfer arm (58) that is attached to the transfer apparatus (50) and to the locking portion (48),
and wherein the carrier transfer mechanism (38) simultaneously transfers a plurality of the carrier (21, 21A) from the loading-ejecting chamber (13) to the film forming chamber (11), and from the film forming chamber (11) to the loading-ejecting chamber (13).

2. The thin-film solar cell manufacturing apparatus (10) according to claim 1, further comprising:
a substrate replacement chamber (15) that is connected to the loading-ejecting chamber (13) via a second opening-closing part (36);
a substrate conveying mechanism (17) that performs an operation of attaching the substrate to the carrier (21, 21A) and an operation of removing the substrate from the carrier (21, 21A); and
a storage mechanism (19) that stores at least one of the substrate attached to the carrier (21, 21A) and the substrate removed from the carrier (21, 21A),
wherein the carrier transfer mechanism (38) transfers the carrier (21, 21A) between the loading-ejecting chamber (13) and the substrate replacement chamber (15);
the substrate conveying mechanism (17) performs the operation of attaching the substrate to the carrier (21, 21A) and the operation of removing the substrate from the carrier (21, 21A) within the substrate replacement chamber(15); and
the substrate conveying mechanism (17) holds the substrate by suctioning a rear surface of the surface to be film-formed of the substrate, and transfers the substrate between the substrate replacement chamber (15) and the storage mechanism (19).

3. The thin-film solar cell manufacturing apparatus (10) according to claim 1,
wherein the carrier (21, 21A) holds a plurality of the substrates so that the substrates are parallel to each other and face each other.

4. The thin-film solar cell manufacturing apparatus (10) according to claim 1,
wherein the film forming chamber (11) has a plurality of cathodes and anodes which face both surfaces of the cathodes; and
the carrier (21, 21 A) is transferred to the film forming chamber (11) so that the substrate is inserted between the cathode and the anode.

5. The thin-film solar cell manufacturing apparatus (10) according to claim 1,
wherein the film forming chamber (11) has a film forming unit which have one cathode and two anodes which face both surfaces of the cathode; and
the carrier (21, 21A) is transferred to the film forming chamber (11) so that the substrate is inserted between the cathode and the anode.

6. The thin-film solar cell manufacturing apparatus (10) according to claim 5,
wherein the film forming chamber (11) has a plurality of the film forming units.

7. The thin-film solar cell manufacturing apparatus (10) according to claim 5 or 6,
wherein the film forming unit is mounted removably from the film forming chamber (11).

8. The thin-film solar cell manufacturing apparatus (10) according to claim 2,
wherein the storage mechanism (19) stores the substrate in a horizontal posture in which the surface to be film-formed of the substrate is horizontal;
the carrier (21, 21A) stores the substrate in a vertical posture in which the surface to be film-formed of the substrate is vertical; and
the substrate conveying mechanism (17) has a rotating mechanism which rotates the substrate between the vertical posture and the horizontal posture.

9. The thin-film solar cell manufacturing apparatus (10) according to any one of claims 1 to 8, further comprising a plurality of process modules in which one film forming chamber (11) is connected to one loading-ejecting chamber (13),
wherein the plurality of process modules are arranged in parallel.

10. The thin-film solar cell manufacturing apparatus (10) according to any one of claims 1 to 9,
wherein a plurality of the film forming chambers (11) is connected to one loading-ejecting chamber (13).

11. The thin-film solar cell manufacturing apparatus (10) according to claim 2, further comprising a plurality of the process modules in which one film forming chamber (11) is connected to one loading-ejecting chamber (13),
wherein the plurality of process modules are arranged in parallel; and
one substrate conveying mechanism (17) is installed in common to the plurality of process modules.

## Patentansprüche

1. Dünnfilmsolarzellen-Herstellungsvorrichtung (10), umfassend:
eine Filmbildungskammer (11), die auf einen reduzierten Druck evakuiert ist und einen Film auf einem Substrat unter Verwendung eines CVD-Verfahrens bildet;
eine Lade-Entlade-Kammer (13), die mit der Filmbildungskammer (11) über einen ersten Öffnungs-Schließ-Teil (25) verbunden ist und die zwischen einem atmosphärischen Druck und einem reduzierten Druck schaltbar ist;
eine Transferschiene (37), die an der Filmbildungskammer (11) und der Lade-Entlade-Kammer (13) verlegt ist;
einen Träger (21, 21A), der sich entlang der Transferschiene (37) bewegt und das Substrat in einer vertikalen Orientierung hält, in der eine Fläche des Substrats, auf der ein Film zu bilden ist, parallel zu einer Richtung der Gravitationskraft ist; und
einen Trägertransfermechanismus (38), der den Träger (21, 21A) transferiert,
wobei der Trägertransfermechanismus (38) in der Lade-Entlade-Kammer (13) bereitgestellt ist,
wobei der Trägertransfermechanismus (38) beinhaltet:
einen Feststellabschnitt (38), der den Träger feststellt;
ein Paar von Führungselementen (49), die an beiden Enden des Feststellabschnitts (48) bereitgestellt sind und die parallel zu der Transferschiene (37) angeordnet sind;
eine Transfervorrichtung (50), die den Feststellabschnitt (48) entlang der Führungselemente (49) bewegt, und
einen Transferarm (58), der an der Transfervorrichtung (50) und an dem Feststellabschnitt (48) angebracht ist,
und wobei der Trägertransfermechanismus (38) gleichzeitig eine Mehrzahl der Träger (21, 21A) von der Lade-Entlade-Kammer (13) zu der Filmbildungskammer (11) und von der Filmbildungskammer (11) zu der Lade-Entlade-Kammer (13) transferiert.

2. Dünnfilmsolarzellen-Herstellungsvorrichtung (10) nach Anspruch 1, des Weiteren umfassend:
eine Substrataustauschkammer (15), die mit der Lade-Entlade-Kammer (13) über einen zweiten Öffnungs-Schließ-Teil (36) verbunden ist;
einen Substratübermittlungsmechanismus (17), der einen Vorgang des Anbringens des Substrats an dem Träger (21, 21A) und ein Vorgang des Entfernens des Substrats von dem Träger (21, 21A) ausführt; und
einen Speichermechanismus (19), der zumindest eins von dem Substrat, das an dem Träger (21, 21A) angebracht ist, und dem Substrat, das von dem Träger (21, 21A) entfernt ist, speichert,
wobei der Trägertransfermechanismus (38) den Träger (21, 21A) zwischen der Lade-Entlade-Kammer (13) und der Substrataustauschkammer (15) transferiert;
wobei der Substratübermittlungsmechanismus (17) den Vorgang des Anbringens des Substrats an den Träger (21, 21A) und den Vorgang des Entfernens des Substrats von dem Träger (21, 21A) in der Substrataustauschkammer (15) ausführt; und
wobei der Substratübermittlungsmechanismus (17) das Substrat durch Ansaugen einer zu der Fläche des Substrats, auf der ein Film zu bilden ist, rückseitigen Fläche hält und das Substrat zwischen der Substrataustauschkammer (15) und dem Speichermechanismus (19) transferiert.

3. Dünnfilmsolarzellen-Herstellungsvorrichtung (10) nach Anspruch 1,
wobei der Träger (21, 21A) eine Mehrzahl der Substrate so hält, dass die Substrate parallel zueinander sind und sich gegenüberstehen.

4. Dünnfilmsolarzellen-Herstellungsvorrichtung (10) nach Anspruch 1,
wobei die Filmbildungskammer (11) eine Mehrzahl von Kathoden aufweist, sowie Anoden, die beiden Flächen der Kathoden gegenüberstehen; und
wobei der Träger (21, 21A) zu der Filmbildungskammer (11) so transferiert wird, dass das Substrat zwischen die Kathode und die Anode eingebracht wird.

5. Dünnfilmsolarzellen-Herstellungsvorrichtung (10) nach Anspruch 1,
wobei die Filmbildungskammer (11) eine Filmbildungseinheit aufweist, die eine Kathode aufweist, sowie zwei Anoden, die beiden Flächen der Kathode gegenüberstehen; und
wobei der Träger (21, 21A) zu der Filmbildungskammer (11) so transferiert wird, dass das Substrat zwischen die Kathode und die Anode eingebracht wird.

6. Dünnfilmsolarzellen-Herstellungsvorrichtung (10) nach Anspruch 5,
wobei die Filmbildungskammer (11) eine Mehrzahl der Filmbildungseinheiten aufweist.

7. Dünnfilmsolarzellen-Herstellungsvorrichtung (10) nach Anspruch 5 oder 6,
wobei die Filmbildungseinheit so montiert ist, dass sie von der Filmbildungskammer (11) entfernbar ist.

8. Dünnfilmsolarzellen-Herstellungsvorrichtung (10) nach Anspruch 2,
wobei der Speichermechanismus (19) das Substrat in einer horizontalen Orientierung speichert, in der die Fläche des Substrats, auf der ein Film zu bilden ist, horizontal ist;
wobei der Träger (21, 21A) das Substrat in einer vertikalen Orientierung speichert, in der die Fläche des Substrats, auf der ein Film zu bilden ist, vertikal ist; und
wobei der Substratübermittlungsmechanismus (17) einen rotierenden Mechanismus aufweist, der das Substrat zwischen der vertikalen Orientierung und der horizontalen Orientierung rotiert.

9. Dünnfilmsolarzellen-Herstellungsvorrichtung (10) nach einem der Ansprüche 1 bis 8, des Weiteren umfassend eine Mehrzahl von Prozessmodulen, in denen eine Filmbildungskammer (11) mit einer Lade-Entlade-Kammer (13) verbunden ist,
wobei die Mehrzahl von Prozessmodulen parallel zueinander angeordnet sind.

10. Dünnfilmsolarzellen-Herstellungsvorrichtung (10) nach einem der Ansprüche 1 bis 9,
wobei eine Mehrzahl der Filmbildungskammern (11) mit einer Lade-Entlade-Kammer (13) verbunden sind.

11. Dünnfilmsolarzellen-Herstellungsvorrichtung (10) nach Anspruch 2, des Weiteren umfassend eine Mehrzahl von Prozessmodulen, in denen eine Filmbildungskammer (11) mit einer Lade-Entlade-Kammer (13) verbunden ist,
wobei die Mehrzahl von Prozessmodulen parallel zueinander angeordnet sind; und
wobei ein Substratübermittlungsmechanismus (17) so installiert ist, dass er der Mehrzahl von Prozessmodulen gemeinsam ist.

## Revendications

1. Dispositif (10) de fabrication de cellules solaires en film mince, comprenant :
une chambre (11) de formation de film, qui est mise sous vide jusqu'à une pression réduite et qui forme un film sur un substrat en utilisant un procédé CVD ;
une chambre (13) d'éjection d'un chargement, qui est reliée à la chambre (11) de formation de film, par l'intermédiaire d'une première partie (25) d'ouverture-fermeture, et qui peut être commutée entre une pression atmosphérique et une pression réduite ;
un rail (37) de transfert, qui est posé dans la chambre (11) de formation de film et dans la chambre (13) d'éjection d'un chargement ;
un transporteur (21, 21A) qui se déplace sur le rail (37) de transfert et qui maintient le substrat dans une posture verticale, où une surface à former en film du substrat est parallèle à la direction de la force de gravité ; et
un mécanisme (38) de transfert du transporteur qui transfère le transporteur (21, 21A),
dans lequel le mécanisme (38) de transfert du transporteur est prévu dans la chambre (13) d'éjection d'un chargement,
dans lequel le mécanisme (38) de transfert d'un transporteur comprend :
une partie (48) de verrouillage qui verrouille le transporteur ;
une paire d'éléments (49) de guidage qui sont prévus aux deux extrémités de la partie (48) de verrouillage et qui sont disposés parallèlement au rail (37) de transfert ;
un appareil (50) de transfert qui déplace la partie (48) de verrouillage le long des éléments (49) de guidage, et
un bras (58) de transfert, qui est adjoint à l'appareil (50) de transfert et à la partie (48) de verrouillage,
et dans lequel le mécanisme (38) de transfert d'un transporteur transfère simultanément une pluralité du transporteur (21, 21A) de la chambre (13) d'éjection d'un chargement à la chambre (11) de formation d'un film et de la chambre (11) de formation d'un film à la chambre (13) d'éjection d'un chargement.

2. Dispositif (10) de fabrication de cellule solaire en couche mince suivant la revendication 1, comprenant en outre :
une chambre (15) de remplacement d'un substrat, qui est reliée à la chambre (13) d'éjection d'un chargement par l'intermédiaire d'une deuxième partie (36) d'ouverture-fermeture ;
un mécanisme (17) de convoyage d'un substrat, qui effectue une opération d'adjonction du substrat au transporteur (21, 21A) et une opération de retrait du substrat du transporteur (21, 21A) ; et
un mécanisme (19) de stockage qui stocke au moins l'un des substrats adjoints au transporteur (21, 21A) et du substrat retiré du transporteur (21, 21A),
dans lequel le mécanisme (38) de transfert d'un transporteur transfère le transporteur (21, 21A) entre la chambre (13) d'éjection d'un chargement et la chambre (15) de remplacement d'un substrat ;
le mécanisme (17) de convoyage d'un substrat effectuant l'opération d'adjonction du substrat au transporteur (21, 21A) et l'opération de retrait du substrat du transporteur (21, 21A) dans la chambre (15) de remplacement d'un substrat ; et
le mécanisme (17) de convoyage d'un substrat retient le substrat en aspirant une surface arrière de la surface à former en film du substrat et transfère le substrat entre la chambre (15) de remplacement d'un substrat et le mécanisme (19) de stockage.

3. Dispositif (10) de fabrication de cellule solaire en couche mince suivant la revendication 1,
dans lequel le transporteur (21, 21A) maintient une pluralité des substrats, de manière à ce que les substrats soient parallèles les uns aux autres et se fassent face.

4. Dispositif (10) de fabrication de cellule solaire en couche mince suivant la revendication 1,
dans lequel la chambre (11) de formation d'un film a une pluralité de cathodes et d'anodes qui font face aux deux surfaces des cathodes ; et
le transporteur (21, 21A) est transféré à la chambre (11) de formation d'un film, de manière à ce que le substrat soit inséré entre la cathode et l'anode.

5. Dispositif (10) de fabrication de cellule solaire en couche mince suivant la revendication 1,
dans lequel la chambre (11) de formation d'un film a une unité de formation d'un film qui a une cathode et deux anodes qui font face aux deux surfaces de la cathode ; et
le transporteur (21, 21A) est transféré à la chambre (11) de formation d'un film, de manière à ce que le substrat soit inséré entre la cathode et l'anode.

6. Dispositif (10) de fabrication de cellule solaire en couche mince suivant la revendication 5,
dans lequel la chambre (11) de formation d'un film a une pluralité d'unités de formation d'un film.

7. Dispositif (10) de fabrication de cellule solaire en couche mince suivant la revendication 5 ou 6,
dans lequel l'unité de formation de film est montée de manière à pouvoir être retirée de la chambre (11) de formation d'un film.

8. Dispositif (10) de fabrication de cellule solaire en couche mince suivant la revendication 2,
dans lequel le mécanisme (19) de stockage stocke le substrat dans une posture horizontale dans laquelle la surface à former en film du substrat est horizontale ;
le transporteur (21, 21A) stocke le substrat dans une posture verticale dans laquelle la surface à former en film du substrat est verticale ; et
le mécanisme (17) de convoyage d'un substrat a un mécanisme tournant qui fait tourner le substrat entre la posture verticale et la posture horizontale.

9. Dispositif (10) de fabrication de cellule solaire en couche mince suivant l'une quelconque des revendications 1 à 8, comprenant en outre une pluralité de modules de processus, dans lequel une chambre (11) de formation d'un film est reliée à une chambre (13) d'éjection d'un chargement,
dans lequel la pluralité de modules de processus sont montés en parallèle.

10. Dispositif (10) de fabrication de cellule solaire en couche mince suivant l'une quelconque des revendications 1 à 9,
dans lequel une pluralité des chambres (11) de formation d'un film est reliée à une chambre (13) d'éjection de chargement.

11. Dispositif (10) de fabrication de cellule solaire en couche mince suivant la revendication 2, comprenant en outre une pluralité des modules de processus, dans lequel une chambre (11) de formation d'un film est reliée à une chambre (13) d'éjection de chargement,
dans lequel la pluralité des modules de processus sont montés en parallèle ; et
un mécanisme (17) de convoyage d'un substrat est commun à la pluralité de modules de processus.
